# NEUE EUROPÄISCHE PATENTSCHRIFT

(11) **EP 1 902 334 B2**
(45) Veröffentlichungstag und Bekanntmachung des Hinweises auf die Entscheidung über den Einspruch: **04.04.2018**
(45) Hinweis auf die Patenterteilung: 30.07.2014
(21) Anmeldenummer: 06763828.8
(22) Anmeldetag: 22.06.2006
(51) Int. Cl.: G02B 5/30, G01J 1/42, G01J 4/04, H01L 31/0232, H01L 27/146, H04N 13/04

(54) **VERFAHREN ZUR HERSTELLUNG VON POLARISATIONSFILTERN SOWIE ANWENDUNG AUF POLARISATIONSEMPFINDLICHE PHOTOSENSOREN UND POLARISATIONSERZEUGENDE WIEDERGABEGERÄTE**
METHOD FOR PRODUCING POLARISATION FILTERS AND USE OF POLARISATION-SENSITIVE PHOTO-SENSORS AND POLARISATION-GENERATING REPRODUCTION DEVICES
PROCÉDÉ DE PRODUCTION DE FILTRES DE POLARISATION, UTILISATION DE CES FILTRES DE POLARISATION SUR DES PHOTOCAPTEURS SENSIBLES À LA POLARISATION, ET APPAREILS DE REPRODUCTION GÉNÉRATEURS DE POLARISATION

(30) Priorität: 08.07.2005 DE 102005031966
(43) Veröffentlichungstag der Anmeldung: 26.03.2008
(73) Patentinhaber: Grau, Günter, 46282 Dorsten (DE)
(72) Erfinder: Grau, Günter, 46282 Dorsten (DE)
(74) Vertreter: Gottschald, Jan
(86) Internationale Anmeldenummer: PCT/EP2006/063435
(87) Internationale Veröffentlichungsnummer: WO 2007/006630

(56) Entgegenhaltungen:
- EP-A1- 1 507 137
- EP-A2- 0 779 499
- DE-U1- 29 805 392
- US- - 3 804 522
- US- - 5 815 269
- US-A- 5 038 041
- US-A- 6 144 512
- US-A1- 2003 146 374
- US-A1- 2004 120 041

## Beschreibung

### Erfindungsgebiet:

Die vorliegende Erfindung betrifft Verfahren zur Herstellung polarisationsempfindlicher bzw. polarisierender Filter sowie die Anwendung auf polarisationsempfindliche Photosensoren zur Messung der Polarisation des einfallenden Lichts, Ausgestaltungen von polarisationsempfindlichen Sensoren zur Messung von Drehwinkeln und starken elektrischen oder magnetischen Feldern sowie weiterhin polarisationserzeugende Wiedergabegeräte.

### Hintergrund:

Eine wichtige Eigenschaft von Licht, die dem menschlichen Auge normalerweise nicht zugänglich ist, ist die Polarisation. Während manche Insekten sich schon lange mit Hilfe des polarisierten Streulichts am Himmel orientieren, nutzen Menschen erst spät die Polarisation aus. Sonnenbrillen unterdrücken gezielt das Streulicht des Himmels. Photographen setzen drehbare Polfilter vor das Objektiv, um Spiegelungen an Glasscheiben oder anderen Oberflächen zu unterdrücken. In der Qualitätskontrolle ist die Schlierenphotographie ein wichtiges Instrument, sie kann etwa Verspannungen in einer Glasflasche sichtbar machen. Weithin bekannt ist auch, dass das durch zwei lineare Polfilter hindurchtretende Licht vom relativen Drehwinkel der beiden Polfilter abhängt - seine Intensität ändert sich nach dem Malus-Gesetz mit dem cos² des Winkels. Dieses Gesetz kann zur Winkelmessung und in Anzeigegeräten ausgenutzt werden.

Das derzeit wohl bedeutendste Einsatzgebiet von Polarisatoren ist die Displaytechnik. Flüssigkristallanzeigen (LCD) verwenden großflächige Polfilterfolien mit konstanter Polarisationsrichtung, um durch optische Drehung oder Umorientierung in einem Flüssigkristall zwischen zwei derartigen Polfilterfolien einen Wechsel zwischen Hell und Dunkel zu erzeugen. Die großtechnische Herstellung von Polarisationsfolien stellt heute kein Problem mehr dar. Das Funktionsprinzip einer solchen Polfilterfolie besteht darin, etwa langkettige Moleküle, die als mikroskopische Antennen dienen, durch mechanische Behandlung während der Herstellung (Walzen, Strecken, Reiben, äußere elektrische oder magnetische Felder) parallel auszurichten. Fällt Licht dergestalt ein, dass die Schwingungsebene des elektrischen Feldes parallel zu den als Mikroantenne wirkenden Molekülen verläuft, regt es einen Strom an. Das Licht wird dadurch je nach Beschaffenheit der Mikroantennen absorbiert oder reflektiert. In Querrichtung hingegen findet keine nennenswerte Wechselwirkung statt, das Licht tritt hindurch. Voraussetzung für eine Polarisationsabhängigkeit ist, dass die Abstände der Mikroantennen hinreichend klein gegenüber der Lichtwellenlänge sind. Beschreibungen für derartige Herstellungsverfahren finden sich z. B. in DE 696 01 621 T2, in der auch Güte und Lebensdauer derartiger Folien beschrieben wird, DE 690 29 683 T2, sowie DE 689 27 986 T2, die auch mustermäßige Herstellung von Polfiltern beschreibt, jedoch ohne örtlich verschiedene Orientierung. In DE 41 14 229 A1 wird die großtechnische Herstellung von polarisierenden Gießfolien mit großer Herstellungsgeschwindigkeit beschrieben. DE 40 26 892 A1 beschreibt weitere Klassen von Gießfolien. DBP 1 015 236 beschreibt ein Herstellungsverfahren, bei dem die polarisierende Wirkung auf Wellenlängen im ferneren Infrarot ausdehnen lässt. DE 199 33 843 B4 geht auf die Herstellung eines LCD-Displays unter Verwendung unstrukturierter Polfilterfolien ein, zudem wird dort die lithographische Strukturierung von Elektrodenmaterial beschrieben.

Die Herstellung eines Polarisators im Kleinen, besonders die Erzeugung von polarisierten Bereichen mit gezielter unterschiedlicher Ausrichtung ist schwierig. Eine Polfilterfolie zu zerschneiden und wie ein Puzzle zusammenzusetzen ist nicht wirtschaftlich und hinsichtlich der Justagetoleranzen nicht präzise genug. Der noch junge Zweig der Nanotechnologie befasst sich u. a. mit der Herstellung von optischen Gittern und Nanoröhrchen bzw. Nanodrähten, häufig aus Kohlenstoff oder Eisen (T.P. Hülser et al, "Self-assembled Iron Nanowires: Morphology, Electrical and Magnetic Properties", Materials Research Society Symposium Proceedings Vol. 877E, 2005), jedoch ist die Beherrschung der Fertigungsprozesse nicht einfach. Auch die gezielte Ausrichtung der so erzeugten Strukturen verursacht Probleme. Nach derzeitigem Stand der Technik ist es nicht wirtschaftlich möglich, ein Mikroarray von Polarisatoren mit gezielt unterschiedlichen Orientierungen herzustellen. DE 100 26 080 A1 beschreibt ein Verfahren, bei dem eine zunächst großflächig homogen polarisierte Folie durch selektive Nachbehandlung stellenweise ihre polarisierende Wirkung verliert, sowie eine Methode, ein örtlich in unterschiedlicher Richtung polarisierendes Filter aus mehreren derartigen Folien zusammenzusetzen. Neben der Dämpfung nimmt auch das Gewicht des Filters mit jeder zusätzlichen Lage zu, zudem ist es schwierig, die so präparierten Folien exakt auf einem Träger zu justieren und zu fixieren. Gezielte Polymerisation einer Ausgangssubstanz durch Bestrahlung mit polarisiertem Licht wurde ebenfalls beschrieben, bleibt jedoch qualitativ hinter den durch mechanische Behandlung hergestellten Folien zurück.

Für die Messung von Drehwinkeln gibt es eine Vielzahl von Anwendungen mit einer ebensolchen Vielzahl von Messverfahren. Eine sehr häufige Problemstellung ist die Winkelmessung an rotierenden Teilen, etwa zur Positionsbestimmung eines Signalgebers (Steuerknüppel, Pedal etc.) oder eines Servos.

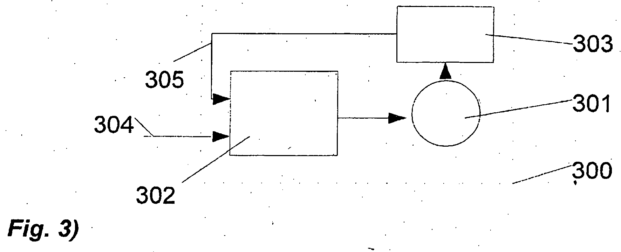

Ein Servo 300 bekommt eine Sollgröße 304, etwa eine Winkelvorgabe, und muss diese selbsttätig in eine mechanische Position umsetzen **(****Fig. 3****).** Dazu besitzt es einen Sensor 303 und einen Regelkreis 302, der den Servomotor 301 geeignet ansteuert. Klassische Servos verwenden zur Messung ein Potentiometer. Dieses wird mechanisch mit einer Achse des Motors oder Getriebes verbunden und erlaubt die Messung z. B. eines Drehwinkels. Ein konventionelles Potentiometer besteht aus einem leitfähigen Kreisscheibensegment aus Graphit oder Leitplastik mit Anschlüssen an beiden Enden. Ein mechanischer Schleifer hat Punktkontakt mit dem leitenden Kreisscheibensegment und greift die Spannung von diesem Kontaktpunkt ab. Je nach Drehwinkel entsteht so ein Spannungsteiler mit Teilungsverhältnis zwischen ideal 0% und 100%, der eine Vergleichsgröße zur Positionierungsinformation 0%-100% darstellt. Ein offensichtliches Problem stellt der mechanische Verschleiß dar, da der Schleifer die Oberfläche berühren muss. Zudem ist eine spielfreie Montage des Schleifers auf einer Welle erforderlich. Das Servo muss eine Reibungskraft überwinden, um den Schleifer zu bewegen, was bei Kleinstservos ebenfalls problematisch sein kann. Für Anwendungen, die eine freie Rotation erfordern, sind Potentiometer ebenfalls nicht geeignet.

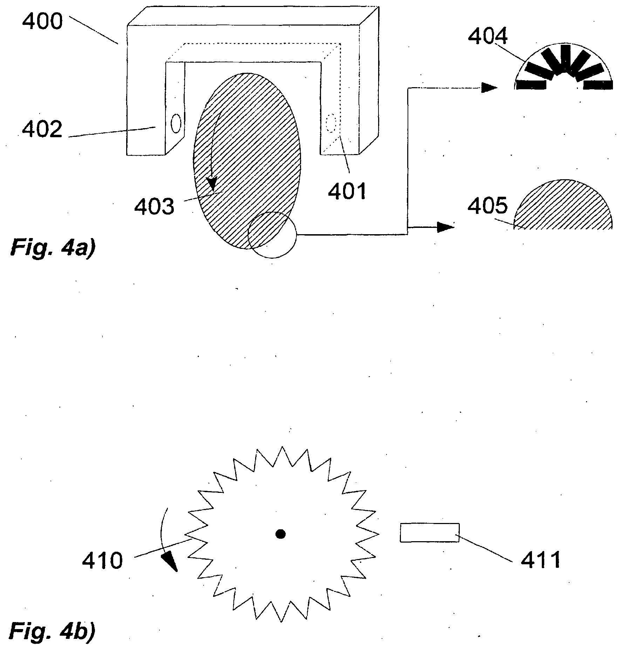

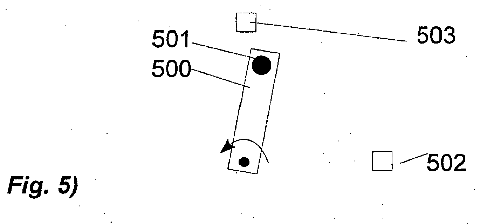

Eine ebenfalls häufig anzutreffende Lösung zur Winkelmessung liegt in der Verwendung einer Gabellichtschranke 400 in Kombination mit einer Schlitzblende 404 oder Kodierscheibe (**Fig. 4a**). Neben dem Umstand, dass hier normalerweise nur relative Positionsänderungen gemessen werden (absolut kodierte Kodierscheiben sind aufwendig und erfordern auch relativ viel Aufwand zur Erfassung der Signale), ist die Erzeugung eines digitalen Signals für Regelungszwecke nicht unbedingt hilfreich. Die Positionierungsgenauigkeit des Servos wird durch die Anzahl Schlitze pro Umdrehung auf der Blende bestimmt. Eine beliebige Erhöhung stößt auf Grenzen, da die Justage immer genauer werden muss und die Schmutz- und Beschädigungsempfindlichkeit stark zunehmen. Um diese Grenzen zu überwinden, kann entweder ein mechanisches Getriebe vorgesehen werden, oder der Umfang der Schlitzblende muss erhöht werden. Beides steht einer Miniaturisierung und Kostenreduktion im Weg. Ferner gibt es auch induktive und kapazitive Positionssensoren 411, die etwa durch Zählen von Spannungsspitzen im Vorbeiflug eines Zahnrad-Zahnes 410 arbeiten **(****Fig. 4b****)** und somit prinzipiell die gleichen Probleme aufweisen. Analoge Winkelmessung in begrenztem Winkelbereich (z. T. nur einige 10°) kann auch durch Entfernungsmessung von zwei verschiedenen Referenzpositionen 502, 503 zu einem Signalgeber 501 geschehen. So kann das Verhältnis zweier induktiv oder kapazitiv gewonnener Messgrößen zur Position eines Zeigers 500 ein Signal liefern, das dem eines Potentiometers ähnelt - jedoch ohne mechanischen Verschleiß und Reibung **(****Fig. 5****).** Die Begrenzung auf enge Winkel sowie die räumliche Ausdehnung der Messanordnung stehen der Miniaturisierung wieder entgegen.

In allen oben beschriebenen Fällen kommen weitere Schwierigkeiten hinzu. Die Genauigkeit der Messung bzw. die Funktion des Sensors hängt von mechanischen Toleranzen ab. Weiterhin ist keines der Messprinzipien für extrem hohe Drehgeschwindigkeiten geeignet.

Für die Wiedergabe stereoskopischer Bilder, einem der Anwendungsgebiete der vorliegenden Erfindung, gibt es verschiedene konkurrierende Verfahren. In DE 199 24 096 C2 werden drei Grundfarblaser (R/G/B) und ein holographischer Schirm zusammen mit orthogonalen Polarisatoren verwendet, um eine positionsunabhängige Betrachtung eines projizierten Stereobildes zu ermöglichen. Der Wechsel zwischen verschiedenen Polarisationsebenen erfolgt mit optischen Modulatoren und Phasenplättchen im Lichtweg. Eine Miniaturisierung kann hier nur begrenzt erfolgen.

In DE 195 10 671 A1 wird ein LCD-Bildschirm beschrieben, der mit jedem Pixel unterschiedliche Anteile orthogonaler Polarisationsrichtungen erzeugen kann. Hierbei wird eine Art Doppel-LCD-Struktur verwendet, wobei die erste Struktur für Intensität und Farbe, die zweite Struktur für die Umorientierung des polarisierten Lichts bzw. die anteilige Zerlegung in orthogonale Komponenten zuständig ist. Mechanische Probleme, Justageprobleme und Gewicht dürften bei dieser Lösung noch immer erheblich sein, wenngleich diese Erfindung eine deutliche Verbesserung gegenüber den dort beschriebenen Alternativen bietet und insbesondere weder eine Auflösungsreduktion noch eine Reduktion der Bildrate aufweist. Dieser Effekt wird jedoch nicht durch ortsselektive Polfilter, sondern durch ortsselektive Ansteuerung von Flüssigkristallen erreicht. Die Ansteuerung dieses Displays erfordert einen speziellen Berechnungsschritt, bei dem zwei Einzelbilder geeignet überlagert werden. Vollständig unabhängige Bildinhalte für das linke und rechte Auge bzw. für verschiedene Betrachter können vermutlich nicht ohne Artefakte dargestellt werden, da keine unabhängigen Pixel zur Verfügung stehen. Es ist vorstellbar, einzelne Pixel ortsfest fest anzusteuern, so dass eine Matrix mit unterschiedlich polarisierten LCD-Pixeln entsteht. In diesem Fall käme der Bildschirm einer Ausgestaltung dieser Erfindung nahe. Allerdings reduziert sich dann die effektive Auflösung des Schirmes. Zudem ist unklar, mit welcher Präzision die zweite LCD-Schicht das Licht drehen kann, also wie vollständig die Trennung der Teilbilder erfolgen kann.

Weitere Ausgestaltungen eines Photodetektor-Arrays mit darauf aufgebrachten Polarisationsfiltern unterschiedlicher Orientierung sind aus US 5,038,041 bekannt.

### Offenbarung der Erfindung:

Der vorliegenden Erfindung liegt daher die Aufgabe zugrunde, ein gerät mit eng umgrenzten und vorbestimmt ausgerichteten Polarisationsfiltern zur Verfügung zu stellen sowie darauf aufbauend Anwendungsbeispiele zu beschreiben, deren Nutzung bislang eher problematisch ist.

Die zuvor hergeleitete und aufgezeigte Aufgabe wird durch ein Gerät mit den Merkmalen von Anspruch 1 gelöst. Weitere vorteilhafte Ausgestaltungen sind in der abhängige Ansprüchen angegeben.

Wesentliche Voraussetzung ist, dass die kleinsten Strukturen, die erzeugt werden können, kleiner als die Wellenlänge des zu polarisierenden Lichts sind. Dies ist für infrarotes Licht beispielsweise bei 130 nm-Technologien der Fall. Bei der lithographischen Herstellung werden per CAD gezeichnete Strukturen auf eine Belichtungsmaske übertragen. Nach Beschichtung eines Wafers mit einem lichtempfindlichen Lack bzw. Photolack wird die Photomaske dazu verwendet, bestimmte Bereiche des Lacks vor dem Licht einer nachfolgenden Belichtung zu schützen. Anschliessend werden selektiv die belichteten bzw. unbelichteten Bereiche des Lacks weggeätzt. Auf diese Weise werden gezielte Bereiche des Wafers für andere Herstellungsschritte zugänglich. Soll etwa ein Polarisationsfilter in einer Metallisierungsebene hergestellt werden, wird üblicherweise vor dem Aufbringen des Photolacks ganzflächig Metall auf den Wafer aufgedampft. Nach der Belackung und Freiätzung der durch die Belichtungsmaske definierten Bereiche wird in den nicht mehr durch Lack geschützten Bereichen das Metall weggeätzt. Wird anschließend der restliche Lack entfernt, bleibt die gemäß CAD-Daten strukturierte Metallisierung übrig. Heutige Technologien verfügen über mehrere Verdrahtungsebenen. Mit Strukturen in der Größenordnung von 100nm kann jedoch in einer Ebene nur ein geringes Kontrastverhältnis erzielt werden.

In einem Verfahren zur Herstellung eines polarisationsempfindlichen Filters mit gezielter Ausdehnung und Orientierung, bei dem auf einen mit Lack beschichteten Träger wird eine polarisierte Substanz vorgegebener Polarisationsrichtung in einem bestimmten Winkel relativ zu dem Träger unter Einwirkung mindestens einer physikalischen und/oder chemischen Einflussgröße wie Druck, Temperatur oder dergleichen aufgebracht, wobei bestimmte Bereiche des Trägers, beispielsweise durch Belichtung und Ätzung, vom Lack befreit sind, und wobei nach Härtung und/oder Abkühlung der polarisierten Substanz auf dem Träger das überschüssige polarisierte Material und/oder Lack der noch abgedeckten Bereiche durch Ätzung und/oder Politur entfernt wird.

Die polarisierte Substanz vorgegebener Polarisationsrichtung kann dabei zuvor mit Verfahren hergestellt werden, wie sie zur Herstellung großflächiger Polarisationsfolien, beispielsweise für LCD-Displays, üblich sind. Beispielsweise bildet ein Material mit langkettigen Molekülen, Nanoröhrchen bzw. Nanodrähten durch mechanische Behandlung wie Dehnen und Walzen Polarisationseigenschaften aus, da sich die langkettigen Moleküle, Nanoröhrchen bzw. Nanodrähten parallel ausrichten. Das Material zur Anwendung nach dem hier beschriebenen Verfahren sollte vorzugsweise eine zähflüssige Konsistenz haben oder in diese gebracht werden können, beispielsweise durch Zugabe von Lösungsmitteln oder unter Einwirkung einer äußeren Kraft wie Druck und/oder Wärme. Vorteilhaft kann die polarisierte Substanz von einer festen Transferfolie oder einer Walze auf den Träger übertragen werden. Die Festlegung der zu beschichtenden Bereiche erfolgt dabei in ähnlicher Weise wie bei der lithographischen Erzeugung von Strukturen auf einer monolithisch integrierten Schaltung. Beispielsweise bietet die mit vorteilhafterweise aus der Lithographie bekanntem Photolack und einem gängigen Belichtungs- und Ätzvorgang präparierte Vorlage an dedizierten Stellen Öffnungen, in die das Filtermaterial hineingepresst wird und anhaftet. Die Orientierung des Filtermaterials wird bei diesem Vorgang nicht verändert. Durch spezielle Behandlung sollte das so übertragene Filtermaterial gehärtet, also dauerhaft gemacht werden. Da das Material auch auf mit Photolack abgedeckten Bereichen liegt, kann anschließend eine chemische oder mechanische Reinigung erfolgen, bei der die beschichtete Oberfläche soweit abgetragen und planarisiert wird, bis eine ebene Anordnung von mit Photolack geschützten und mit Filtermaterial beschichteten Bereichen entsteht. Je nach weiterer Bearbeitung kann der verbleibende Photolack nun komplett oder teilweise entfernt werden, um die darunter liegenden Bereiche freizulegen.

In einem weiteren Beispiel enthält eine Vorrichtung zur Messung zur Messung der Polarisation von Licht ist mindestens ein sensorisches Element mit einem Polarisationsfilter zu einem polarisationsempfindlichen Sensor als bauliche Einheit zusammenwirkend angeordnet, dessen Polarisationsebene in einem vorbestimmten Winkel relativ zu einer festgelegten Bezugsachse des sensorischen Elementes ausgerichtet ist, wobei die Bezugsachse anhand einer Markierung am Gehäuse der Vorrichtung kenntlich gemacht ist. Dies kann im einfachsten Fall durch Aufkleben einer Polarisationsfolie auf ein sensorisches Element, beispielsweise eine Photodiode, geschehen, oder durch Anwendung von Verfahren nach einem der Ansprüche 1 bis 9 oder weiterer Alternativen. Die bauliche Einheit eines polarisationsempfindlichen Sensors mit bekannter exakter Ausrichtung der Polarisationsebene bildet die Grundlage für die Ausnutzung der Polarisation in einer Vielzahl von Anwendungen, wie sie teilweise in den Unteransprüchen dieser Erfindung beschrieben werden. Die nötige Kenntnis der Orientierungsrichtung des Filters sowie die exakte Ausrichtung von Sensor und Filter zueinander bewirken, dass die bauliche Einheit die Anwendbarkeit erheblich erleichtert, sie erfordert aufgrund der Kenntlichmachung am Sensorgehäuse keine optischen Spezialwerkzeuge.

In einem weiteren Beispiel enthält eine Vorrichtung zur Messung der Polarisation von Licht, mindestens ein sensorisches Element, wobei über dem sensorischen Element mit lithographischen Methoden erzeugte Gitterstrukturen in mindestens einer Fertigungsebene und/oder Verdrahtungsebene vorgesehen sind, deren geometrische Struktur und Orientierung zuvor durch den Entwurf von Maskendaten festgelegt wurde, derart, dass ein polarisationsempfindlicher Sensor als bauliche Einheit gebildet wird, wobei vorzugsweise nur die beim Entwurf integrierter Schaltungen üblichen Strukturgrößen verwendet werden und die üblichen Fertigungsschritte zur Herstellung integrierter Schaltungen zum Einsatz gekommen sind. Die Anwendung von Herstellungsschritten, die zur Herstellung integrierter Schaltungen üblich sind, sowie die Beschränkung auf diese, führen zu der Möglichkeit, Integrierte Schaltungen mit polarisationsempfindlichen optischen Sensoren ohne zusätzlichen Aufwand herzustellen. Die Erzeugung und Ausrichtung der Filter gegenüber dem Sensor erfolgt dabei mit gleich hoher Präzision wie beim Rest der Integrierten Schaltung. Die Struktur des Polarisationsfilters wird dabei anhand von Maskendaten beschrieben, die auch die übrige Fertigung steuern. Voraussetzung ist im wesentlichen, dass die kleinsten Strukturen, die gefertigt werden können, kleiner als die zu polarisierende Wellenlänge sind. Die Gitterperiode eines Filters mit parallelen Streifen sollte deutlich kleiner als die Hälfte der Wellenlänge sein. Die Filter in Form von Gitterstrukturen mit gezielter Ausdehnung und Orientierung können mit lithographischen Methoden in mindestens einer Fertigungsebene und/oder Verdrahtungsebene erzeugt werden, deren geometrische Struktur und Orientierung zuvor durch den Entwurf von Maskendaten festgelegt wurde, wobei vorteilhaft nur die beim Entwurf integrierter Schaltungen erlaubten Strukturgrößen verwendet werden (sog. Design-Regeln). Bei heute gängigen Strukturgrössen von 130 nm oder weniger ist eine signifikante polarisierende Wirkung im Bereich des infraroten Lichts erreichbar. Kann in einer 130 nm-Technologie mit einem einlagigen Filter ein Kontrastverhältnis von etwa 1:3 erreicht werden, etwa für 1.5 µm Wellenlänge, so potenziert sich in erster Näherung der Kontrast bei Hintereinanderschaltung mehrerer Filterlagen gemäß der Verkettung der Übertragungsfunktionen. Bei Ausnutzung aller fein strukturierbaren Poly- und Metallisierungsebenen können so in Standardtechnologien hohe Kontrastverhältnisse erzielt werden, ohne dass ein einziger zusätzlicher Prozessschritt erforderlich ist. Neben der Einsparung der separaten Herstellung einer Filterfolie kann mit dieser Methode die Anzahl Sensoren pro Fläche erheblich gesteigert werden, so dass sich mehr Information auf gleichem oder kleinerem Raum gewinnen lässt. Bei besonderer Wahl der Geometrie der gestapelten Filterebenen bzw. bei bestimmten Wellenlängen können Resonanzeffekte vorteilhaft ausgenutzt werden, um den Kontrast weiter zu steigern.

In einem weitere Beispiel ist zur Erzeugung von polarisiertem Licht mindestens ein Lichtemitter mit einem Polarisationsfilter zu einem polarisierenden Lichtemitter als bauliche Einheit zusammenwirkend angeordnet, dessen Polarisationsebene in einem vorbestimmten Winkel relativ zu einer festgelegten Bezugsachse des Lichtemitters ausgerichtet ist, wobei die Bezugsachse anhand einer Markierung am Gehäuse der Vorrichtung kenntlich gemacht ist. Für eine derartige bauliche Einheit ergeben sich ähnliche Vorteile in der Anwendung wie bei der Vorrichtung nach Anspruch 10, etwa dass die Erzeugung von exakt ausgerichtetem polarisiertem Licht keine speziellen optischen Instrumente erfordert.

In einem weitere Beispiel sind zur Erzeugung von polarisierten Lichtsignalen, insbesondere Bildsignalen, mindestens mehrere Lichtemitter vorgesehen, die periodisch mit einem polarisierenden Filter unterschiedlicher vorherbestimmter Orientierung ausgestattet sind, wobei die polarisierenden Filter unterschiedlicher Orientierung vorzugsweise in einer Ebene liegen. Vorteilhaft ist eine periodische Anordnung aus Gruppen von polarisierenden Lichtemittern, deren Polarisationsebenen dem eines komplementären polarisationsempfindlichen Bildsensors entsprechen. In diesem Fall kann ein Bild mit Polarisationsinformation wiedergegeben werden.

In einem weiteren Beispiel wird eine Projektionsvorrichtung zur vorzugsweisen Wiedergabe von stereoskopischen Bildern, beschrieben wobei, ein Projektor zwei Halbbilder auf eine Projektionsfläche strahlt, die mit einem Polarisationsfilter mit räumlich unterschiedlicher Polarisationsrichtung ausgestattet ist, wobei vorzugsweise abwechselnd zwei zueinander orthogonale Polarisationsebenen verwendet werden.

Vorteilhafte Ausgestaltungen der zuvor beschriebenen erfindungsgemäßen Gegenstände sind Gegenstand der Unteransprüche und werden im Folgenden näher erläutert. Gemäß einer vorteilhaften Ausgestaltung des Verfahrens zur Herstellung eines Polarisationsfilters werden ferromagnetische Materialien zur lithographischen Strukturierung verwendet.

Aufgrund der Permeabilität µᵣ wird die Skintiefe σ reduziert, wodurch dünnere Schichten zur Absorbtion des einfallenden Lichtes verwendet werden können. Dünnere Filter sind von Vorteil, wenn Licht unter einem großem Winkel zur Normalen einfällt.

Gemäß einer weiteren vorteilhaften Ausgestaltung der Verfahren werden die zur Polarisation genutzten Leiterbahnen kammartig verschaltet. Dabei wird das dazwischenliegende Dielektrikum durch Anlegen einer hohen Spannung gestresst und damit der Brechungsindex beeinflusst. Auf diese Weise lässt sich das Verhalten des Filters elektrisch beeinflussen.

Gemäß einer weiteren vorteilhaften Ausgestaltung der Verfahren werden die zur Polarisation genutzten Leiterbahnen so verschaltet, dass sie von einem Heizstrom durchflossen werden können, um den Brechungsindex zu beeinflussen. Auf diese Weise lässt sich das Verhalten des Filters elektrisch beeinflussen.

Gemäß einer vorteilhaften Ausgestaltung der Verfahren zur Herstellung eines Polarisationsfilters werden zur Herstellung der polarisierenden Substanz Nanodrähte mit einem Durchmesser größer als die Skintiefe der zu filternden Wellenlänge in ein Dielektrikum eingebettet, wobei für die Nanodrähte vorzugsweise ein ferromagnetisches Material wie Eisen verwendet wird.

Gemäß einer weiteren vorteilhaften Ausgestaltung der Verfahren wird als Dielektrikum zwischen den leitfähigen polarisierenden Strukturen des Filters ein Material mit niedrigem Brechungsindex verwendet, das zu einem Metamaterial mit noch niedrigerer Dielektrizitätskonstante umgeformt wird, um die Polarisationseigenschaften bei gegebener Wellenlänge und Geometrie der polarisierenden Strukturen zu verbessern bzw. um die benötigten minimalen Strukturgrößen zu vergrößern. Als Metamaterial gilt in diesem Zusammenhang insbesondere eine aufgeschäumte bzw. poröse Substanz. Geeignete Ausgangsstoffe sind z.B. Glas (SiO₂, εᵣ ≈ 4) oder BenzoCycloButene (BCB, C₈H₆, εᵣ ≈ 2.5), wobei die Poren vorzugsweise luftgefüllt sind.

Gemäß einer weiteren vorteilhaften Ausgestaltung der Verfahren werden Teile des Dielektrikums des Polarisationsfilters nach der Herstellung durch selektives Ätzen entfernt, um ausgedehnte Bereiche mit minimaler Dielektrizitätskonstante zu erzeugen. Die Größe der so erzeugten Kavitäten ist vorzugsweise so zu bemessen, dass die polarisierenden Strukturen vom verbleibenden umliegenden Dielektrikum getragen werden. Vorteilhaft ist daher das Ätzen von balkenförmig ausgedehnten Gräben quer zur Orientierung der polarisierenden Strukturen, wobei die Breite der Gräben größer als die Wellenlänge des zu filternden Lichts sein kann. Die von den polarisierenden Strukturen durchsetzten Kavitäten sind vorzugsweise luftgefüllt.

Gemäß einer vorteilhaften Ausgestaltung des Verfahrens zur Herstellung eines Polarisationsfilters wird das Verfahren sukzessive mit unterschiedlicher Ausrichtung der polarisierten Substanz gegenüber dem Träger auf unterschiedliche Bereiche des Trägers angewendet, wobei die zuvor hergestellten polarisierenden Bereiche vorzugsweise mit einer dünnen Lackschicht geschützt werden, die am Ende der Herstellung entfernt werden kann. Hierdurch entstehen exakt abgegrenzte Bereiche bekannter und unterschiedlicher Orientierung, die in derselben Ebene liegen und damit die geringstmögliche Distanz zu einem Lichtssensor oder Lichtemitter aufweisen können. Gegenüber alternativen Verfahren, bei denen zur Erzielung desselben Effekts mehrere Filterlagen mit deaktivierten Bereichen eingesetzt werden, ergeben sich hierdurch Gewichts- und Kostenvorteile.

Gemäß einer vorteilhaften Ausgestaltung der erfindungsgemäßen Vorrichtung zur Messung der Polarisation von Licht ist mindestens ein sensorisches Element vorgesehen, wobei über dem sensorischen Element mit lithographischen Methoden erzeugte Gitterstrukturen in mindestens einer Fertigungsebene und/oder Verdrahtungsebene vorgesehen sind, deren geometrische Struktur und Orientierung zuvor durch den Entwurf von Maskendaten festgelegt wurde, derart, dass ein polarisationsempfindlicher Sensor als bauliche Einheit gebildet wird, wobei vorzugsweise nur die beim Entwurf integrierter Schaltungen üblichen Strukturgrößen verwendet werden und die üblichen Fertigungsschritte zur Herstellung integrierter Schaltungen zum Einsatz gekommen sind.

Gemäß einer vorteilhaften Ausgestaltung der erfindungsgemäßen Vorrichtung zur Messung der Polarisation von Licht werden mindestens zwei polarisationsempfindlichen Sensoren, von denen zumindest einer nach einem der vorangehenden Ansprüche ausgebildet ist, mit unterschiedlicher Ausrichtung der Polarisationsebenen vorgesehen, wobei Einrichtungen vorgesehen sind, um aus den Signalen der polarisationsempfindlichen Sensoren eine Aussage über die Polarisation des einfallenden Lichtes zu treffen. Die Einrichtung kann etwa durch Verhältnisbildung von jeweils zwei Sensorsignalen die Polarisationsebene von einfallendem polarisierten Licht unabhängig von seiner Helligkeit bestimmen. Vorteilhaft sind Polarisationsebenen, deren Orientierung 45° oder geringerer abweicht, da die Verhältnisbildung bei geringer Anforderung an die Linearität ohne Linearisierung des aufgrund des Malus-Gesetzes nichtlinearen Sensorverhaltens erfolgen kann.

Gemäß einer weiteren vorteilhaften Ausgestaltung der erfindungsgemäßen Vorrichtung zur Messung der Polarisation von Licht wird eine Vielzahl polarisationsempfindlicher Sensoren so angeordnet und in ihrer jeweiligen Polarisationsrichtung so orientiert, dass sie zur Aufnahme eines Bildes mit Informationen über die Polarisation des einfallenden Lichtes geeignet sind. Dazu wird zweckmäßigerweise zunächst eine regelmäßige Struktur von Photosensoren erzeugt, wie sie für Bildsensoren üblich ist. In einem späteren Fertigungsschritt werden für alle Sensorelemente, die polarisationsempfindlich gemacht werden sollen, Polarisationsfilter in einer festgelegten periodischen Orientierung aufgebracht. Vorteilhaft ist etwa eine periodische Zelle mit 2*2 Sensoren und je 45° verdrehten Filtern. Anwendung kann ein solcher Sensor etwa in der Qualitätskontrolle finden, wo eine mit einer derartigen Vorrichtung erweiterte Schlierenphotographie Aussagen über Stärke und Art von Verspannungen ermöglicht.

Gemäß noch einer weiteren vorteilhaften Ausgestaltung der erfindungsgemäßen Vorrichtung zur Messung der Polarisation von Licht ist mindestens ein Farbfilter vorgesehen. Besonders vorteilhaft ist diese Ausgestaltung bei einer regelmäßigen Struktur von Photosensoren, die zur Aufnahme eines Bildes geeignet sind, da der Informationsgehalt des Bildes weiter gesteigert wird. Neben einer Realisierung mit separaten farb- und polarisationsempfindlichen Photosensoren ist eine weitere Realisierung möglich, bei der beide Filterarten je Photoelement kombiniert angewendet werden. Die geeignetste Ausgestaltung ergibt sich, wenn eine Filteranordnung dergestalt gewählt wird, dass sich das aufgenommene Signal bei Verwendung ausschließlich unpolarisierten Lichts nicht von dem Signal eines herkömmlichen Farb-Bildsensors unterscheidet. Ein gängiges Bildsensorlayout ist das Bayer-Layout, bei dem ein Farbpixel aus einem Array aus 2*2 Photoelementen gebildet wird und Farbfilter für z. B. rot, grün, grün und blau aufweist. Werden je vier Farbpixel in Form eines 2*2-Arrays zu einem Superpixel zusammengefasst, wobei vorteilhaft jedes Farbpixel innerhalb des Superpixels eine 45° abweichende Ausrichtung des Polarisationsfilters gegenüber dem Nachbarfarbpixel aufweist, ändert sich für unpolarisiertes Licht das Verhalten und die Auflösung des Sensors im Vergleich zu einem konventionellen Farbsensor nicht, lediglich die einfallende Lichtmenge reduziert sich auf etwa die Hälfte. Im Falle vollständig polarisierten Lichts ist die effektive Auflösung auf 25% reduziert, da jedes Farbpixel bevorzugt nur Licht der korrekten Polarisationsebene registriert. In der anschließenden Bildbearbeitung kann eine vollständige Summation der Information aller Farbpixel jedes Superpixels zu einem Ersatzpixel erfolgen, um dasselbe Bild zu erhalten, das ein nicht polarisationsempfindlicher Bildsensor aufgenommen hätte. Bei geeigneter Gewichtung der Summation kann jedoch für jedes Superpixel entschieden werden, ob, wie stark und in welcher Orientierung polarisiertes Licht dargestellt bzw. unterdrückt werden soll. Weist eine photographierte Szene etwa mehrere unterschiedliche Spiegelungen auf, deren Licht in unterschiedlicher Orientierung polarisiert ist, kann ein Photograph nach dem Stand der Technik nur eine Spiegelung mit Hilfe eines drehbar vor dem Objektiv angeordneten Polfilters entfernen. Ein bereits aufgenommenes Bild von einer herkömmlichen Kamera kann nicht mehr geeignet weiterverarbeitet werden, da es keinerlei Informationen über den Polarisationszustand enthält. Mit der erfindungsgemäßen Vorrichtung kann der Photograph nun im Nachhinein beide Spiegelungen gezielt entfernen, er kann jedoch auch Spiegelungen gezielt verstärken. In der beschriebenen vorteilhaften Ausgestaltung dieser Vorrichtung ist dies zudem in einer farbselektiven Weise möglich. Neben künstlerischen Aspekten ist ein socher Sensor auch zum Einsatz in Überwachungskameras, beispielsweise in der Verkehrsüberwachung zur Eliminierung von Spiegelungen, geeignet. Da jeder einzelne Photosensor individuelle ortsbezogene Information enthält, ist zur späteren Darstellung eine geschicktere Manipulation der Sensordaten als die Summation zu einem Ersatzpixel möglich, so dass im Idealfall nur eine lokale und unmerkliche Reduktion der Bildauflösung in den Bereichen auftritt, wo starke Polarisation auftritt und/oder gezielt manipuliert wird.

Gemäß einer weiteren vorteilhaften Ausgestaltung der erfindungsgemäßen Vorrichtung zur Messung der Polarisation von Licht wird mit einem polarisierten Lichtemitter sowie einem polarisationsempfindlichen Sensor der Drehwinkel zwischen dem polarisierenden Lichtemitter und dem polarisationsempfindlichen Sensor ermittelt. Die Verwendung von polarisiertem Licht ermöglicht eine berührungsfreie und kraftfreie Messung von Winkeln ohne aufwendige Justage. Besonders vorteilhaft ist die Verwendung von gekennzeichneten baulichen Einheiten polarisierter Lichtemitter und polarisationsempfindlicher Empfänger nach Anspruch 10 bzw. 22, da spezielle optische Werkzeuge zur Justage der Filter entfallen.

Gemäß einer weiteren vorteilhaften Ausgestaltung der erfindungsgemäßen Vorrichtung zur Messung der Polarisation von Licht wird ein drehbares Polarisationsfilter zwischen mindestens einem polarisationsempfindlichen Sensor und mindestens einem Lichtemitter vorgesehen. Diese Vorrichtung ähnelt im Aufbau einer Gabellichtschranke mit Schlitzblende, wobei anstelle der Schlitzblende das Polarisationsfilter tritt. Bei kleinen Abmessungen ist mit Schlitzblenden nur eine geringe Auflösung zu erreichen, da die kleiner werden Schlitze zu erhöhter Justageanforderung führen und die Ausfallwahrscheinlichkeit aufgrund von Schmutz oder Beschädigung steigt. Bei Verwendung des Polarisationsfilters treten diese Probleme nicht auf.

Gemäß einer weiteren vorteilhaften Ausgestaltung der erfindungsgemäßen Vorrichtung zur Messung der Polarisation von Licht wird mindestens ein polarisationsempfindlicher Sensor, ein Lichtemitter, ein drehbares Polarisationsfilter und ein reflektierendes Medium relativ zueinander dergestalt angeordnet, dass von dem Emitter ausgehendes Licht am reflektierenden Medium reflektiert werden kann, durch das drehbare Polarisationsfilter treten kann und von mindestens einem polarisationsempfindlichen Sensor erfasst werden kann. Bei dieser Ausgestaltung können Emitter und Sensor gemeinsam in einer Ebene angeordnet werden, auch gemeinsam integriert werden, so dass sich eine kompaktere und leichtere Bauform im Vergleich zu einer Gabellichtschranke ergibt. Die Anordnung von Polarisationsfilter und reflektierendem Medium, beispielsweise Papier oder mattes Metall, erlaubt die Messung von Drehwinkeln auch in Situationen, wo keine Durchlichtmessung möglich ist. So kann diese Anordnung auf einem Zahnrad oder gar einer Welle angebracht sein. Größe und Gewicht der Vorrichtung werden dadurch sehr reduziert, die Anwendung kann aufgrund kleinerer Fliehkräfte auch bei sehr hohen Drehzahlen erfolgen.

Gemäß einer weiteren vorteilhaften Ausgestaltung der erfindungsgemäßen Vorrichtung zur Messung der Polarisation von Licht wird der polarisationsempfindliche Sensor zusammen mit einer Vorrichtung zur Ansteuerung eines Aktuators und zum Vergleich des Messsignals mit einer Sollgröße zusammenwirkend angeordnet, insbesondere integriert. Insbesondere bei einer Vorrichtung nach Anspruch 17 können Servos mit minimalem Fertigungs- und Justageaufwand bei gleichzeitig minimaler Größe realisiert werden. Erfolgt die Winkelmessung direkt an der Motorwelle eines Servomotors, reduziert sich die Größe des Servos praktisch auf die Größe des Motors. Für kleine Stellwinkelschritte sind Schrittmotoren oder Ultraschallmotoren besonders geeignet.

Gemäß einer weiteren vorteilhaften Ausgestaltung der erfindungsgemäßen Vorrichtung zur Messung der Polarisation von Licht sind Mittel zur elektronischen Kalibration und/oder Speicher zur Speicherung von Kalibrationsdaten vorgesehen. Diese Daten können die Zuverlässigkeit und Präzision der Vorrichtung erhöhen, insbesondere dann, wenn nichtideales Verhalten berücksichtigt werden soll. Zu nichtidealem Verhalten gehört neben dem Malus-Gesetz auch die unvollständige Polarisation des Filters oder Leckströme. Gemäß einer weiteren vorteilhaften Ausgestaltung der erfindungsgemäßen Vorrichtung zur Messung der Polarisation von Licht sind Mittel zur automatischen Kalibration vorgesehen. So können Kalibrationsdaten nach erstmaliger Inbetriebnahme oder zwischenzeitlich im Betrieb ermittelt und/oder aktualisiert werden. Ändert sich eine Servo-Sollvorgabe etwa über einen hinreichend großen Winkel, so ist sichergestellt, dass mindestens ein polarisationsempfindlicher Sensor zwischenzeitlich einen minimalen Messwert liefert, der mit verschiedenen nichtidealen Verhalten korrespondiert. Teure und aufwendige manuelle Justagen können so vermieden werden.

Gemäß einer weiteren vorteilhaften Ausgestaltung der erfindungsgemäßen Vorrichtung zur Messung der Polarisation von Licht ist mindestens ein polarisationsempfindlicher Sensor, ein transparentes Medium und ein polarisierter Lichtemitter vorgesehen, wobei das polarisierte Licht des Emitters nach Durchtritt durch das transparente, vorzugsweise zur Ausnutzung des Faradayeffekts oder Kerreffektes geeignete, Medium vom polarisationsempfindlichen Sensor erfasst wird. Eine derartige Vorrichtung ist zur Messung starker statischer und dynamischer Magnetfelder oder elektrischer Felder geeignet und erfordert lediglich das transparente Medium in definierter Form, jedoch keine elektrischen oder magnetischen Teile im zu messenden Feld. Es ergeben sich daher verschiedene Vorteile gegenüber Hallsonden oder Messspulen, insbesondere auch bei schnell veränderlichen Feldern.

Gemäß einer vorteilhaften Ausgestaltung einer Vorrichtung zur Erzeugung polarisierten Lichts werden zur Betrachtung eines stereoskopischen Bildes und/oder zweier unabhängiger Bilder mit einer Vorrichtung nach einem der Ansprüche 22 oder 23 Mittel vorgesehen, die unterschiedlichen Betrachtern und/oder den beiden Augen desselben Betrachters durch Verwendung von vorzugsweise drehbaren Polarisationsfiltern nur einen Teil des dargestellten Bildes anzeigen. So kann etwa eine Brille mit zwei drehbaren Polarisationsfiltern dazu verwendet werden, einem Auge nur Information der korrekten Polarisationsrichtung zuzuführen. Auf diese Weise können die zwei Augen eines Betrachters eine Szene betrachten, die aus unterschiedlicher Perspektive aufgenommen wurde, was zu einer räumlichen Wahrnehmung führt. Es können auch verschiedene Informationen dargestellt werden, die getrennt wahrgenommen werden. Es ist ebenso denkbar, dass verschiedene Betrachter verschiedene Informationen wahrnehmen, wenn sie auf dieselbe Vorrichtung schauen.

### Kurzbeschreibung der Zeichnung:

Die Erfindung wird im folgenden anhand von Ausführungsbeispielen näher erläutert, wozu auf die beigefügten Zeichnungen Bezug genommen wird. Es zeigen:
- Fig. 1a:: Abfolge von Prozessschritten zur Strukturierung einer Metallisierungsebene gemäß Stand der Technik und gemäß der vorliegenden Erfindung
- Fig. 1b:: Beispielhafte Strukturierung einer Fertigungsebene mit optisch polarisierender Wirkung gemäß der vorliegenden Erfindung in der Draufsicht
- Fig. 1c:: Beispielhafte Strukturierung einer Fertigungsebene mit optisch polarisierender Wirkung gemäß der vorliegenden Erfindung im Querschnitt
- Fig. 1d:: Beispielhafte Realisierung eines Polfilters mit Kavitäten
- Fig. 2a:: Beispielhafte Übertragung einer Polfilterfolie auf einen Träger
- Fig. 2b,c:: Prozessschritte zur Übertragung bzw. Mikrostrukturierung eines Polfilters auf einem Träger
- Fig. 3:: Servo-Vorrichtung gemäß Stand der Technik
- Fig. 4a:: Gabellichtschranke mit Schlitzblende gemäß Stand der Technik bzw. mit Polfilter
- Fig. 4b:: Winkelmessung mit Zahnrad gemäß Stand der Technik
- Fig. 5:: Induktive oder kapazitive Relativmessung gemäß Stand der Technik
- Fig. 6:: Signalverlauf der individuellen Sensorsignale
- Fig. 7:: Winkelmessung mit reflektivem Polfilter
- Fig. 8:: Vorrichtung zur Messung starker Felder
- Fig. 9a:: Bildsensor mit Polfiltermatrix
- Fig. 9b:: Farb-Bildsensor mit Polfiltermatrix
- Fig. 10:: Bildprojektor mit Polfiltermatrix
Spezielle Beschreibung von Ausführungsbeispielen der Erfindung:

### Beispiel 1: Fertigung von strukturierten Polfiltern mit den Mitteln der Photolithographie bei Beschränkung auf die Fertigungsschritte einer integrierten Schaltung

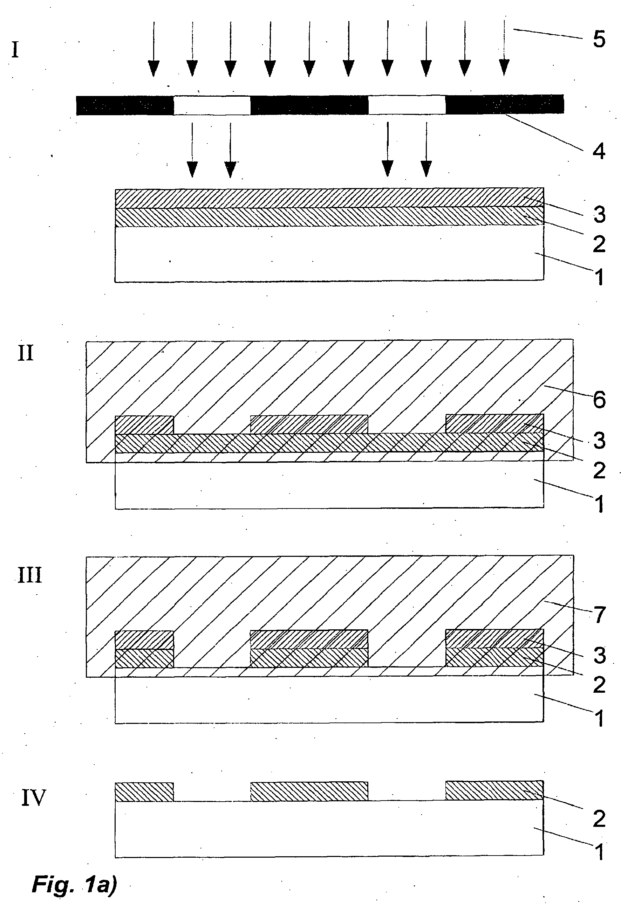

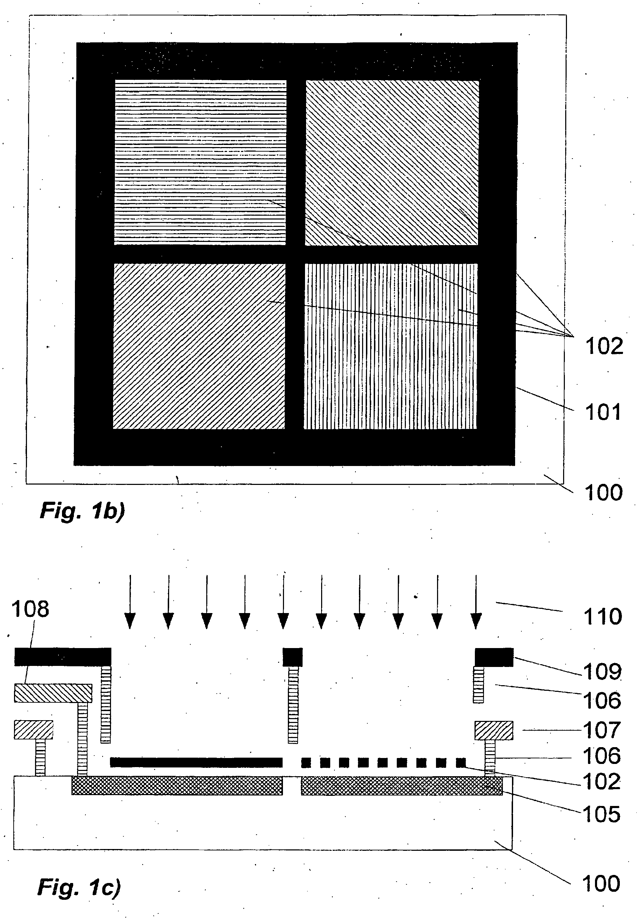

Während die Fertigung von Nanostrukturen mit gezielter Orientierung eher problematisch ist, ist dies in der Mikroelektronik ein lange gelöstes Problem. Die Strukturen werden im CAD-System gezeichnet, auf einer Belichtungsmaske üblicherweise in vergrößertem Maßstab repliziert und und mittels photolithographischer Verfahren von der Belichtungsmaske auf einen Träger bzw. Wafer übertragen (**Fig. 1a**). Dabei wird in der Regel zunächst der Wafer 1 mit einem Photolack 3 überzogen, anschließend wird er durch die Belichtungsmaske 4 hindurch belichtet, so dass bestimmte Teile auf einen nachfolgenden chemischen Prozess ansprechen, also etwa durch eine Lösung 6 freigeätzt werden können. Anschließend kann ein weiterer Ätzvorgang mit einer Ätzlösung 7 durchgeführt werden, um beispielsweise eine zuvor hergestellte ganzflächige Metallisierung 2 zu strukturieren, oder es werden Diffusions- oder Implantationsvorgänge durchgeführt. Die verbliebenen Lackstrukturen 3 schützen in diesen Fällen bestimmte Bereiche vor der Prozessierung. Lange Zeit waren die minimalen Strukturgrößen, die in der Mikroelektronik wirtschaftlich erzeugt werden konnten, nicht klein genug im Verhältnis zur Lichtwellenlänge, um optisch wirksame Filter zu erzeugen. Dies hat sich in jüngster Zeit geändert. Konventionelle 130 nm- oder feinere Fertigungstechnologien erlauben die Herstellung von Polarisationsfiltern ohne Änderung des Fertigungsprozesses. Dazu werden parallele Leiterbahnen auf Gate-Polysilizium oder den Metallebenen über dem Photosensor erzeugt. Zur Steigerung des Kontrastes bietet es sich an, mehrere Fertigungsebenen übereinander zu verwenden, also etwa eine Schichtfolge von Poly, Metall 1, Metall 2, ..., bis Metall N. Da moderne Prozesse z. T. über 2 Poly- und 8 Metallisierungsebenen aufweisen, ist eine Hintereinanderschaltung von bis zu 10 Filtern möglich. Selbst wenn das Kontrastverhältnis eines einzelnen Filters bei einer bestimmten Wellenlänge nur 3 beträgt, so beträgt das von 4 hintereinandergeschalteten Filtern im Idealfall bereits 3⁴=81. Jedoch ist eine Anwendung derzeit vorwiegend auf Infrarotlicht mit den gängigen Wellenlängen 950 nm und 1.5 um wirtschaftlich sinnvoll, da jede Verkleinerung der minimalen Strukturgröße mit aufwendigeren Masken und Belichtungstechniken einhergehen. Besonders interessant ist dieser Ansatz also in den Fällen, wo mit herkömmlichen Fertigungstechnologien brauchbare optische Filter ohne jeglichen Zusatzaufwand realisiert werden können. Speziell Anwendungen mit einem Massenmarkt rechtfertigen die Herstellung in 0.13 um- oder kleineren Technologien, da die höheren Maskenkosten durch die kleineren Stückkosten aufgrund der kleineren Chipfläche überkompensiert werden. Dem Nachteil der Verwendbarkeit nur mit lamgwelligem Licht steht der Vorteil gegenüber, dass ein derartig realisiertes Filter nicht die chemischen oder thermischen Stabilitätsprobleme aufweist wie übliche Polfilterfolien. Daher sind erweiterte Betriebsbedingungen möglich, sowohl zu sehr tiefen als auch zu sehr hohen Temperaturen. **Fig. 1a** zeigt schematisch die Abfolge der Fertigungsschritte für ein einlagiges Filter gemäß Stand der Technik, wie es unverändert auch zur Strukturierung eines Polfilters verwendet werden kann. Technische Details der Fertigung spielen in diesem Zusammenhang keine Rolle, so können gleichermassen Positiv- und Negativverfahren angewendet werden, es kann Röntgenstrahlung statt Licht zur Belichtung verwendet werden, es kann Elektronen- oder Ionenstrahllithographie verwendet werden, die u. U. ganz auf eine Photomaske verzichtet und die Strukturen mit einem gerichteten Strahl in den Lack schreibt. Die Photolithographie wird hier nur bevorzugt behandelt, weil sie gängig und preiswert ist. **Fig. 1b** zeigt ein beispielhaftes einlagiges Sensorlayout in der Draufsicht (vereinfacht und nicht massstäblich). Der Sensor 100 ist hierbei gekennzeichnet durch vorzugsweise metallisch abgedeckte Bereiche 101), unter denen verarbeitende Elektronik liegen kann, und Sensorbereiche 102, die jeweils spezifische Strukturen aufweisen, um Licht zu polarisieren. Die Schraffuren der Bereiche 102 sind dabei sinnbildlich für die Orientierung der hergestellten Strukturen. **Fig. 1c** zeigt den dazugehörigen vereinfachten Querschnitt, wobei als Photosensor pn-Dioden 105 skizziert sind. Zusätzlich zu der Abdeckung 109 sind hier lichtundurchlässige Wände 106 skizziert, die aus Vias bzw. Kontakten hergestellt sind und bei schrägem Lichteinfall eine Beeinflussung benachbarter Sensoren unterbinden. Die Verdrahtungsebenen 107 und 108 dienen hier der Kontaktierung der pn-Dioden 105, während das Polfilter auf einer Poly-Silizium-Schicht 102 realisiert ist, die normalerweise das Gate von MOS-Transistoren formt. Es sei darauf hingewiesen, daß es dielektrische und metallische optische Filter gibt, die sich in der Funktionsweise unterscheiden. Die Behandlung des Poly-Silizium-Layers erlaubt eine Verwendung nach beiden Methoden. Massgeblich für das erfindungsgemässe Verfahren ist lediglich, daß die zur Fertigung verwendeten Daten ein optisches Filter beschreiben, etwa lange parallele Streifen mit möglichst geringer Breite und möglichst geringem Abstand zueinander, zur Erzielung eines linearen Polarisationsfilters oder anderer optischer Filter.

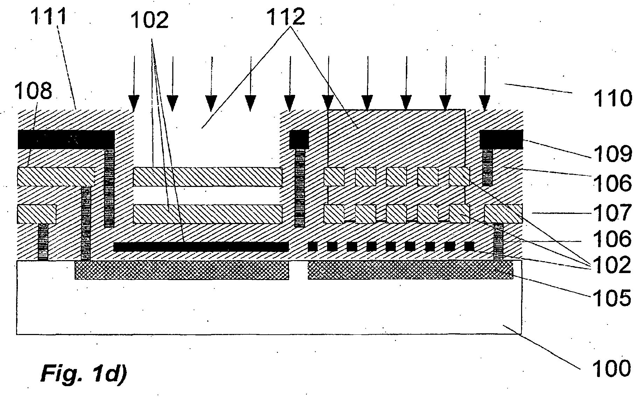

Eine deutliche Verbesserung der polarisierenden Eigenschaften kann bei weitgehender Reduktion der Dielektrizitätskonstante erreicht werden. Das beste Dielektrikum ist folglich Luft (εᵣ=1). Ein typischer Herstellungsprozeß für integrierte Schaltungen hat eine Maske für Passivierungsöffnungen, mit der das Deckoxid über den Bondpads entfernt wird. Aufgrund der Dicke der Passivierung und der hohen Toleranzen in den oberen Schichten ist die erzielbare Ätztiefe üblicherweise sehr hoch und reicht, wenn kein Metall den Vorgang stoppt, bis in die mittleren oder unteren Verdrahtungsebenen hinab. Diese Eigenschaft wird u. a. auch dazu verwendet, um eine Sollbruchstelle an der Aussenkante eines IC zu bilden. In **Fig. 1d** ist ein Schnittbild eines derartigen Filters mit vier übereinanderliegenden Filterebenen 102 gezeigt. Insbesondere die mittleren Verdrahtungsebenen, die normalerweise nicht so fein strukturiert werden können wie die unterste, profitieren von der Entfernung des Dielektrikums. Kommt als Dielektrikum 111 Glas zum Einsatz, so reduziert sich die Grenzwellenlänge für Polarisation um den Faktor 2. Durch die Verwendung der normalen Passivierungsätzung zur Erzeugung der Kavitäten 112 werden ebenfalls zusätzliche Kosten bei der Herstellung vermieden.

### Beispiel 2: Fertigung von strukturierten Polfiltern mit den Mitteln der Photolithographie bei Verwendung von zusätzlichen Fertigungsschritten, die denjenigen zur Herstellung einer integrierten Schaltung vergleichbar sind

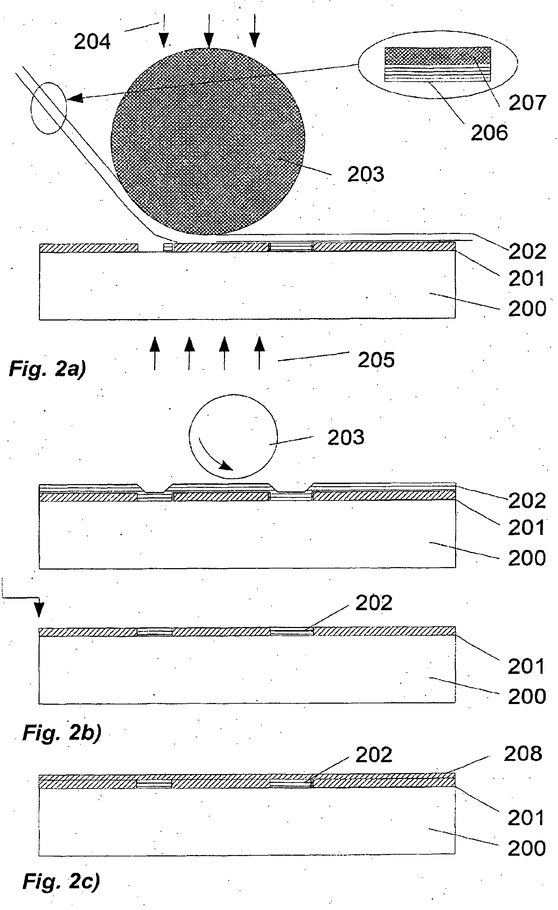

Um ein Polfilter mit kurzwelligerem Licht, also etwa im gesamten sichtbaren Bereich verwenden zu können, ist eine Realisierung mit anderen Mitteln als denen in Beispiel 1 wirtschaftlicher. Da die großtechnische Herstellung von Polfilterfolien mit geeigneten Eigenschaften beherrscht wird, kann eine Kombination von derartigen Folien mit Verfahren der Lithographie verwendet werden, um mikrostrukturierte Polfilter zu erzeugen. Für die benötigten Polfilterfolien können die verschiedensten Herstellungsverfahren zum Einsatz kommen. Neben den üblichen Polymeren bieten sich auch in Harz eingebettete Nanoröhrchen oder Nanodrähte an. Die Fertigung derartiger Filter würde mit vergleichbaren Verfahren geschehen, mit denen großfläche Filter etwa für LCD-Anzeigen erstellt werden. D. h. langkettige Moleküle, Nanoröhrchen oder Nanodrähte werden durch Einfluss einer äußeren Kraft, beispielsweise elektrische oder magnetische Felder oder durch Reiben oder Dehnen, parallel in Kraftrichtung orientiert, wodurch die Orientierungsrichtung.bekannt ist. Damit diese Moleküle bzw. Röhrchen oder Stäbchen ihre Orientierung behalten, können sie in eine Trägersubstanz eingebettet werden, die ihnen mechanische Stabilität verleiht. Wenn eine derartige aushärtbare Substanz mit polarisierender Wirkung 206 auf eine Walze 203 oder Trägerfolie 207 aufgebracht wird, so kann diese Substanz zu einem späteren Zeitpunkt unter Einwirkung einer weiteren äußeren Kraft, etwa Druck 204 und/oder Temperatur 205, auf einen Träger, Wafer bzw. Sensor 200 - übertragen werden (**Fig. 2a**). Durch photolithographische Prozesse können selektiv einzelne Sensorfelder zur Beschichtung freigelegt werden.

Für die Strukturierung der Polfilter durch Lithographie gibt es zwei grundsätzliche Alternativen:
Die erste Alternative ist vergleichbar mit der Strukturierung einer Metallisierungsebene für eine integrierte Schaltung, die Methodik entspricht daher **Fig. 1a**, sofern die Aluminium- bzw. Kupferlage 2 durch eine Polfilterlage ersetzt wird. Nach der vorherigen ganzflächigen Beschichtung des Trägers mit der polarisierenden Substanz wird diese anschließend selektiv weggeätzt. Um in nachfolgenden Schritten Filter mit unterschiedlicher Polarisationsrichtung aufzubringen, würde man vorzugsweise die zuvor freigeätzten Bereiche mit einer nicht polarisierenden Substanz auffüllen und die Oberfläche anschließend planarisieren, um eine einwandfreie Unterlage für nachfolgende Beschichtungsprozesse mit unterschiedlicher Orientierung der polarisierenden Substanz zu bekommen. In diesem Fall entsteht eine Schichtfolge, deren Dicke ein Mehrfaches der Dicke einer Einzelschicht beträgt, wobei Filterbereiche mit unterschiedlicher Orientierung einen unterschiedlichen Abstand zum Träger bzw. Sensor aufweisen, was von Nachteil sein kann. Zudem wird der maximale Lichtdurchtritt durch die Füllsubstanz reduziert.

Es ist auch eine umgekehrte Vorgehensweise möglich. Hierbei wird zunächst mit dem Lithographielack 201 eine Matrix mit Öffnungen erzeugt, in die anschließend die Filtersubstanz 206 eingepresst wird. Nach Aushärtung der Substanz kann das überschüssige Material durch Polierverfahren (CMP) und/oder Ätzverfahren entfernt werden **(****Fig. 2b****).** Sinnbildlich wird durch Schleifkörper 203 das Material abgetragen. Es muss hierbei nicht zu einem direkten Kontakt zwischen Schleifkörper 203 und abzuschleifendem Material 202 und 201 kommen, eine kraftübertragende und ggf. ätzende Flüssigkeit kann ebenfalls vorteilhaft eingesetzt werden. Anschließend können die so präparierten Träger bzw. Sensoren durch eine dünne Deckschicht 208 geschützt werden **(****Fig. 2c****).** Durch mehrfaches Freiätzen der übrigen durch Lack geschützten Felder und Wiederholung des Beschichtungsprozesses unter verschiedenen Winkeln entsteht nach und nach eine Filteranordnung mit selektiven Polarisationsfiltern unterschiedlicher Ausrichtung, entsprechend **Fig. 1b****.** Nach diesen Prozessschritten kann die Oberfläche mit einer dauerhaften Schutzschicht versehen werden. Dieses von der IC-Herstellung leicht abweichende Verfahren hat speziell dann Vorteile, wenn mehrere Filter mit abweichenden Orientierungen realisiert werden sollen, da alle Filterbereiche in derselben Ebene liegen und das Gesamtresultat nur die Dicke einer einzelnen Filterebene aufweist. Da keine Füllmaterialien notwendig sind, entfällt zusätzlicher Lichtverlust, zudem wird das Gewicht minimiert. Da bei diesem Verfahren kein Kontakt zwischen der Lithographiemaske und dem Filtermaterial bzw. Träger notwendig ist, tritt kein mechanischer Verschleiß der Maske auf. Dies ist ein Vorteil gegenüber Mikro- oder Nanoprägetechniken, die ansonsten ebenfalls für die Strukturierung der Polfilter angewendet werden könnten. Zudem entspräche die Herstellung von Prägemasken nicht dem von integrierten Schaltungen her bekannten Verfahren, was sie wirtschaftlich uninteressanter macht.

Vor oder nach der Herstellung der Polarisationsfilter können auch die für CCD- oder CMOS-Bildsensoren üblichen Bearbeitungsschritte wie z. B. Auftragen von Farbfiltern stattfinden. Mikrolinsen wird man vorzugsweise nach den Filtern herstellen, da sie keine ebene Unterlage bieten würden. Diese zusätzlichen Schichten können gleichzeitig als Schutz der relativ empfindlichen Polfilter verwendet werden.

Herstellungstechnische Details sind nicht Bestandteil dieser Erfindung. So sind die Beschichtungsprozesse vermutlich vorzugsweise im Vakum durchzuführen, um Lufteinschlüsse zu vermeiden. Eine Vorbehandlung der Oberfläche von 200 kann erforderlich sein, um die Haftung der Filtersubstanz 206 auf 200 zu verbessern. Diese Fragen hängen von den eingesetzten Materialien und deren Beschaffenheit ab.

### Beispiel 3: polarisationsempfindliche Sensoren zur Winkelmessung

Eine sehr häufige Problemstellung ist die Winkelmessung an rotierenden Teilen, etwa zur Positionsbestimmung eines Signalgebers (Steuerknüppel, Pedal etc.) oder eines Servos. Wie eingangs geschildert, haben gängige Messverfahren Beschränkungen u. a. hinsichtlich der Auflösung bzw. Justagetoleranz bei zunehmender Miniaturisierung sowie der Messgeschwindigkeit. Die Messung von Winkeln durch Ausnutzung der Polarisation von Licht kann viele Probleme vermeiden.

Mit konventionellen Mitteln kann man etwa einen Photosensor hinter einem drehbaren Mess-Polarisationsfilter anordnen, mit polarisiertem Licht unbekannter Orientierung der Polarisationsrichtung bestrahlen und für verschiedene Drehwinkel das gemessene Signal aufnehmen, das sich nach dem Malus-Gesetz ändert. Wenn das Signal ein Maximum aufweist, ist die Orientierung des Mess-Polfilters identisch mit der Polarisationsorientierung des einfallenden Lichts. Dies ist eine mechanisch große und vergleichsweise aufwendige Lösung. Sie setzt zudem voraus, dass sich das zu messende Signal während der Messung nicht ändert. Die Verwendung von mehreren Photosensoren mit fest aufgesetztem Polfilter, etwa einer aufgeklebten Polfilterfolie, stellt dazu eine Alternative dar. Die Polfilterausrichtung jedes Sensors kann z.B. in 90°- oder 45°-Schritten erfolgen. Noch einfacher wäre es, identische polarisierende Sensoren bekannter Polarisationsrichtung als bauliche Einheit zu verwenden und diese in unterschiedlicher Orientierung anzuordnen. Durch Auswertung der Signale aller Sensoren kann die Zusammensetzung des einfallenden Lichtes ermittelt werden. Problematisch ist nun jedoch, dass die optisch wirksame Fläche des Gesamtsensors, bestehend aus zwei oder mehr Einzelsensoren, größer ist als die des einzelnen mechanisch manipulierten Sensors. Das bedeutet, dass das Messsignal gleichmäßig auf der gesamten Sensorfläche zur Verfügung gestellt werden muss.

Durch Integration der Einzelsensoren und der Polarisationsfilter zu einem integrierten Sensor, in der Struktur ähnlich wie in **Fig. 1b****,** wird eine zeitgleiche Messung aller erfassten Polarisationsebenen auf der Fläche eines Einzelsensors möglich. Dieser integrierte Sensor weist daher auch keine Beschränkung hinsichtlich der Änderungsgeschwindigkeit des Eingangssignals auf.

Die Auswertung der einzelnen Sensorsignale kann vorteilhaft mit auf den Sensor integriert werden, so dass ein für den Anwender leicht zu verarbeitendes Messergebnis zur Verfügung gestellt werden kann. Dabei können sowohl analoge als auch digitalisierte Signale bereitgestellt werden.

Im Folgenden wird näher auf die Problematik der Winkelmessung eingegangen.

In einer ersten Ausgestaltung **(****Fig. 4a****)** ähnelt die Anordnung einer Winkelmessung mit Gabellichtschranke 400 und Schlitzblende 404. Eine modifizierte Gabellichtschranke 400 weist auf einer Seite eine Lichtquelle, beispielsweise eine LED, auf 402. Auf der anderen Seite befindet sich ein polarisationsempfindlicher Sensor 401, der vorzugsweise 4 Felder mit in 45° versetzten Polfiltern aufweist. Anstelle der Schlitz- oder Codierblende wird nun jedoch eine drehbar gelagerte unstrukturierte Polfilterfolie 405 zwischen Sender 402 und Empfänger 401 gesetzt. Da die Polarisationsrichtung der Folie ortsunabhängig ist, ist weder eine exakte Justage erforderlich, noch führt Schmutz unmittelbar zu Fehlfunktionen. Schmutz reduziert lediglich die Helligkeit und den Kontrast des Signals.

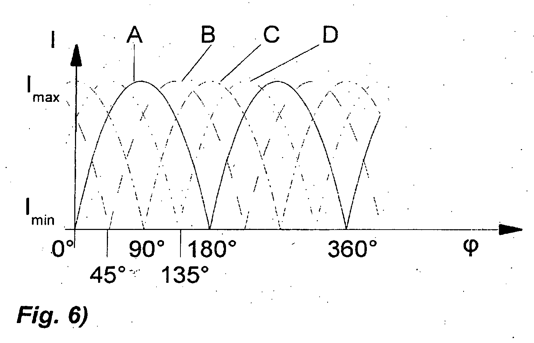

Das bei der Rotation der Polfilterfolie um 360° an den vier Sensoren A,B,C,D entstehende Signalprofil ist in **Fig. 6** gezeigt. Die Sensoren A,B,C,D entsprechen dabei den Feldern 102 in **Fig. 1b**. Das Signal jedes Einzelsensors folgt dabei dem Malus-Gesetz. Für metallische Filter wird bei Lichteinfall mit Polarisationsorientierung in Richtung der Filterstreifen Licht (ϕ=0°) absorbiert oder reflektiert, das Sensorsignal I ist daher minimal Iₘᵢₙ. Bei 90° abweichendem Winkel bekommt der Sensor ein maximales Signal Iₘₐₓ. Ein nichtideales Filter oder unpolarisiertes Streulicht verschiebt die Kurven nach oben, erzeugt also einen Offset. Nach Abzug des Offsets kann eine benachbarten Sensoren gewonnen werden, so dass die absolute Helligkeit keine Rolle spielt. Eine eindeutige Positionsaussage kann für einen Bereich von 180° getroffen werden, indem die einzelnen Signale in Relation gesetzt werden. Durch Kombination mit mindestens einem Hell/Dunkelfeld in Verbindung mit mindestens einer Lichtschranke kann der Messbereich problemlos auf 360° ausgedehnt werden. Vielfältige andere Alternativen sind zur Ausdehnung des Messbereichs auf 360° denkbar. Die Polfilterfolie kann zu diesem Zweck vorteilhaft weiter strukturiert werden, etwa durch Schwärzung bestimmter Bereiche.

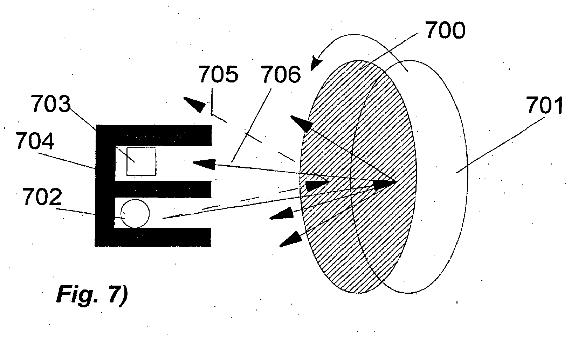

In einer weiteren Ausgestaltung kann die benötigte Filterfläche weiter reduziert werden, zudem können Lichtquelle 702 und Sensor 703 in einer Ebene, also auf einem gemeinsamen Träger 704 montiert werden. Dies ermöglicht eine kleinstmögliche Anordnung mit allen damit verbundenen Vorteilen. Wie in **Fig. 7** gezeigt, erlaubt eine hinter der Polfilterfolie 700 angeordnete Streuscheibe 701, beispielsweise weißes Papier oder die matte Oberfläche eines Getriebezahnrades, Licht von der Quelle 702 in verschiedene Richtungen zu reflektieren. Dies erlaubt eine Anordnung von Sender und Empfänger dergestalt, dass keine Spiegelungen 705 von der Polfilteroberfläche in den Sensor 703 gelangen, sondern nur Signale, die durch das Filter 700 hindurchgetreten sind. Spiegelungen von der Oberfläche des Filters 700 würden das erzielbare Kontrastverhältnis reduzieren. Es ist unerheblich, ob die Streuscheibe 701 zusammen mit dem Filter 700 rotiert, unabhängig davon rotiert, oder nicht rotiert.

Die Ausgestaltung des Winkelsensors mit einem reflektierenden Polarisationsfilter erlaubt die direkte Montage des Filters 700 auf der Motor- oder Getriebewelle. Damit können minimale Schwungmassen erzielt werden. Besonders vorteilhaft kann auch die Servoelektronik zum Soll-Ist-Vergleich und zur Ansteuerung eines Aktuators mit in den Sensorchip integriert werden. Die Montage der Sensoreinheit über der Messstelle, beispielsweise Motorwelle, erfolgt dabei ohne besondere Justageanforderungen. Bei Verwendung eines Mikromotors kann der Sensor etwa im Inneren des Getriebes untergebracht werden. Bei Schrittmotoren oder Ultraschallmotoren kann z. T. ganz auf Getriebe verzichtet werden, ein komplettes Servo ist in diesem Fall kaum größer als der Motor selbst. Die extreme Miniaturisierung des Winkelsensors ggf. zusammen mit einer Servoelektronik auf wenige Kubikmillimeter führt dabei im Gegensatz zu digitalen Messverfahren nicht zu einer Reduktion der Auflösung, erlaubt aber stattdessen Anwendung auch bei extrem hohen Drehzahlen. Eine monolithische Integration von Sender 702 und Sensor 703 ist ebenfalls denkbar.

Zur Kalibration des Sensors können einerseits die Intensitäten aller Sensorfelder A,B,C,D summiert werden, um eine Aussage über die gesamte einfallende Lichtmenge zu bekommen, es kann jedoch auch ein unpolarisierter Hilfssensor verwendet werden. Zur Messung des Streulichtes bzw. des Polarisationsfaktors ist es hilfreich, das Mindestsignal während der Drehung zu erfassen und zu speichern. Neben einer Kalibration ab Werk kann dies auch bei einer Erstinbetriebnahme bzw. später in Wartungszyklen automatisch erfolgen, wobei die Funktion des Sensors durch diese Zyklen nicht beeinträchtigt wird. Die ermittelten Werte werden vorteilhaft in einem nichtflüchtigen Speicher auf dem Sensor (z. B. EEPROM oder Flash) gespeichert, so dass sie nach dem erneuten Einschalten unmittelbar zur Verfügung stehen. Eine weitere vorteilhafte Ausgestaltung ergibt sich, wenn der Referenzpunkt des Sensors elektronisch manipuliert und abgespeichert werden kann, da eine aufwendige mechanische Kalibration des gemessenen Winkels auf diese Weise durch eine elektronische Kalibration ersetzt werden kann.

### Beispiel 4: Messung starker Felder

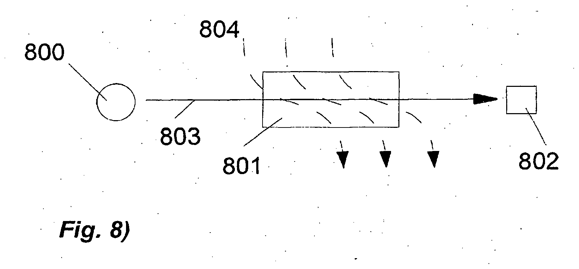

Ein polarisationsempfindlicher Sensor mit einer Filteranordnung beispielsweise nach Fig. 1b kann auch zur Messung starker Magnetfelder unter Ausnutzung des Faradayeffekts bzw. starker elektrischer Felder nach dem Kerreffekt verwendet werden, wie in Fig. 8 gezeigt. Wird linear polarisiertes Licht 803 durch ein Medium 801 geleitet, das einem starken Feld 804 ausgesetzt ist, so dreht sich je nach Feld und Material die Polarisationsebene des Lichts. Diese Drehung kann nun im Winkelsensor 802 erfasst werden. Als Lichtquelle 800 kann vorzugsweise linear polarisiertes Laserlicht verwendet werden. Besonders vorteilhaft an einer derartigen Anordnung ist, dass keinerlei elektrisch leitende oder ferromagnetische Gegenstände dem Feld ausgesetzt sind, also die Beeinflussung des Feldes minimal ist. Aufgrund der praktisch trägkeitslosen Reaktion des Systems können auch sehr schnelle Transienten, wie sie etwa bei Stoßentladungen auftreten, erfasst werden. Dies ist ein Vorteil gegenüber vielen anderen Meßmethoden, beispielsweise Induktionsspulen oder Elektrostaten mit Flügelrad. Die Verwendung eines miniaturisierten optischen Winkelsensors 802 erleichtert die Messung mit Laserstrahlen geringen Querschnitts, ermöglicht also insbesondere auch die Messung räumlich stark begrenzter Felder.

### Beispiel 5: Aufnahme von Bildern mit Polarisationsinformation

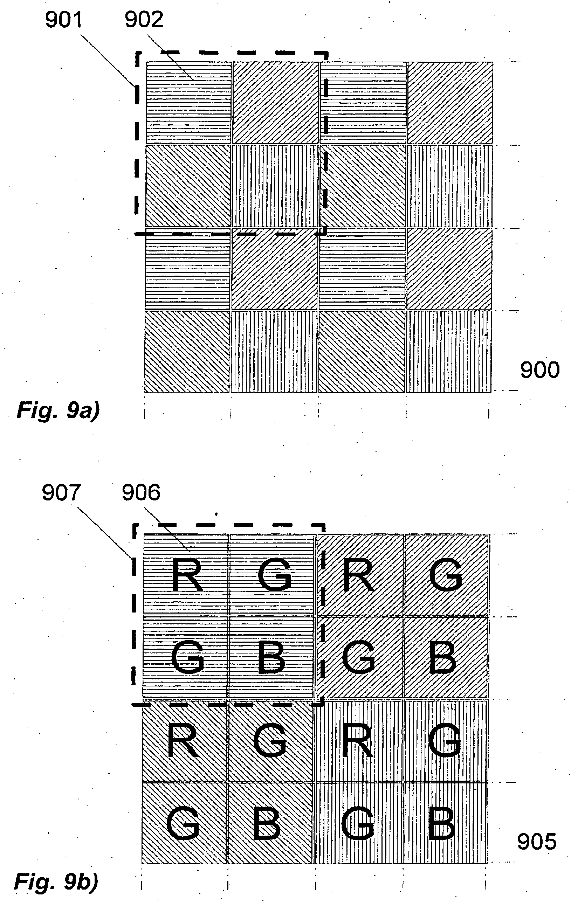

Bei höherer Integration können auch spezielle Anordnungen oder regelmäßige Arrays von polarisationsabhängigen Photosensoren erzeugt werden. So ist es denkbar, ein Pendant zu einem Farb-Bildsensor zu erstellen, der anstelle der Farbfilter (etwa eine quadratische GRBG-Matrix beim sog. Bayer-Format) Polarisationsfilter in unterschiedlichen Richtungen, vorzugsweise mindestens in zwei orthogonalen Richtungen (0° und 90°) oder besser vier Richtungen (0°, 45°, 90°, 135°) aufweist (Fig. 9a). Der Gesamtsensor 900 enthält hierbei Pixelgruppen 901, die aus Photodetektoren mit individuell orientiertem Polfilter 902 bestehen. Schlierenphotographie mit einem solchen Sensor könnte in diesem Fall nicht nur das Auftreten von Spannungen nachweisen, sondern auch bessere Aussagen über die Stärke und die Art der Verspannungen treffen. Die Verwendung von zwei orthogonalen Polfilterorientierungen erlaubt dabei die Bestimmung der Polarisationsorientierung von polarisiertem Licht, kann aber nicht sicher zwischen einfallendem Licht diagonaler Orientierung und unpolarisiertem Licht unterscheiden, da in diesen Fällen beide Filter die gleiche Lichtmenge durchlassen. Die Verwendung von vier unterschiedlichen Polfilterorientierungen gibt zusätzlich Aufschluss über den Grad der Polarisation des einfallenden Lichts. Dies kann beispielsweise zur Ausblendung von Streulicht aus einem Messsignal verwendet werden.

Bei Anlehnung an herkömmliche CCD- oder CMOS-Bildsensoren ist der Aufwand zur Realisierung des Bildsensors und zur Auswertung eines damit gewonnenen Bildes gering. Ohne weiteres kann das Bild auf einem herkömmlichen Graustufen-Monitor betrachtet werden, allerdings ohne erkennbare Polarisationsinformation. Die Polarisationsinformation kann an einem herkömmlichen Farbmonitor als Falschfarbinformation wiedergegeben werden. Vielfältige Anwendungen sind denkbar. Ein Bild eines derartigen Sensors kann durch Bildverarbeitung so manipuliert werden, als wäre es mit einem konventionellen Bildsensor mit einem Polfilter in wahlfreier Orientierung aufgenommen worden. Darüber hinaus können Spiegelungen ortsabhängig, also gezielt und graduell unterdrückt oder verstärkt werden. Automatische Aufnahmen, etwa von Verkehrsüberwachungskameras, können nachträglich, auch automatisch, so bearbeitet werden, dass etwa eine Person trotz ungünstiger Spiegelungen an einer Scheibe erkannt werden kann. Eine Kombination von Polarisationsfilter-Array und Farbfilterarray auf einem Bildsensor erlaubt diese Funktionalität ebenfalls mit Farbbildern. Die größte Flexibilität ergibt sich, wenn die Farbmatrix gegenüber einem herkömmlichen Bildsensor nicht verändert wird, die Polarisationsfilter also jeweils auf benachbarte Farbpixelzellen aufgebracht werden. Fig. 9b zeigt dies für einen Sensor im gängigen Bayer-Format. Der Sensor 905 weist hierbei farbempfindliche Photosensoren 906 auf, wobei jeweils einem kompletten Farbpixel ein Polfilter zugeordnet ist, dessen Orientierung sich periodisch ändert. Beim Bayer-Format ist der grünempfindliche Sensor doppelt vorhanden, um Helligkeitsinformation in dem Bereich, in dem das menschliche Auge besonders empfindlich ist, besonders gut messen zu können. Es ist daher auch eine Anordnung denkbar, in der etwa einer der beiden grünempfindlichen Sensoren kein Polfilter aufweist und daher eine höhere allgemeine Lichtempfindlichkeit aufweist. Vielfältige andere Varianten sind denkbar. Die Herstellungsreihenfolge der unterschiedlichen Filter (Polfilter bzw. Farbfilter) spielt prinzipiell keine Rolle. Im Falle unpolarisierte Lichts unterscheidet sich das Bild eines derartigen Sensors nicht von dem eines konventionellen Farbsensors. Insbesondere eine Reduktion der Bildauflösung entsteht im Falle unpolarisierten Lichts nicht. Bei voll polarisiertem einfallendem Licht geht jedoch ein Teil der räumlichen Auflösung verloren, da kein Licht auf den unter dem Filter liegenden Sensor fällt. Für eine Anordnung mit zwei orthogonalen Filtern beträgt der Verlust der Auflösung folglich schlimmstenfalls 50%, bei Verwendung von vier Filterorientierungen schlimmstenfalls 25%. Im Vergleich zu einem herkömmlichen Bildsensor ohne Polarisationsabhängigkeit ist eine Reduktion der Lichtempfindlichkeit aufgrund der Ausblendung der jeweils ungeeigneten Polarisationsrichtung um ca. Faktor 2 zu beklagen.

### Beispiel 6: Wiedergabe von Signalen oder Bildern mit Polarisationsinformation

Wie in Beispiel 4 deutlich wurde, können für bestimmte Anwendungen Lichtquellen für polarisiertes Licht von Interesse sein. Auch zur Messung von Winkeln kann anstelle einer unpolarisierten Lichtquelle mit rotierendem Polfilter eine direkte Winkelmessung zwischen polarisierter Lichtquelle und Sensor verwendet werden. Auf diese Weise kann etwa ein Winkel über eine große Distanz hinweg ermittelt werden. Die bauliche Einheit aus Lichtquelle und Polfilter ist für derartige Anwendungen zweckmäßig.

Darüber hinaus können Leuchtmittelarrays oder Monitore mit Polfilterarrays ausgestattet werden, um etwa ein Bild, das mit einer polarisationsempfindlichen Kamera aufgenommen wurde, naturgetreu wiederzugeben. Hierzu ist es zweckmäßig, wenn Monitor und Kamera eine ähnliche Filterstruktur aufweisen, zumindest die gleiche Winkelauflösung. In diesem Fall ist kein besonderer Zwischenschritt zur Signalverarbeitung notwendig. Ein breiteres Anwendungsfeld ergibt sich für die Erzeugung von stereoskopischen Bildern. Eine häufige Realisierung stereoskopischer Bilder bedient sich einer Farbbrille, beispielsweise mit einem roten Filter für das linke und einem grünen Filter für das rechte Auge. Der Monitor strahlt monochrome Ansichten einer Szene aus zwei Perspektiven in den entsprechenden Farben aus. Hierbei bekommt das linke Auge Bilder einer ersten, das rechte Auge Bilder einer zweiten Farbe zu sehen. Im Gehirn werden diese Bilder zu einem räumlichen Gesamteindruck zusammengesetzt. Der Vorteil ist, dass dieses Verfahren mit jedem Monitor funktioniert und von der Position und Blickrichtung unabhängig ist. Nachteilig ist jedoch, dass keine korrekte Farbwiedergabe erfolgt. Das Problem der Farbwiedergabe kann durch Shutterbrillen gelöst werden. Der Monitor zeigt abwechselnd zwei Farbbilder, die Shutterbrille (LCD-Display mit einem Element pro Auge) verdunkelt synchron zum Monitor jeweils ein Auge. Nachteilig ist hierbei der Aufwand für die Brille, insbesondere die Notwendigkeit einer Stromversorgung und der korrekten Synchronisation. Zudem sinkt die effektive Bildwiederholrate auf die Hälfte ab. Weiterhin ist diese zeitversetzte Darstellung bei bewegten Bildern anstrengend für den Betrachter.

Eine andere Realisierung verwendet speziell präparierte Monitore, bei der Mikroprismen oder Mikrolinsen in regelmäßigen Abständen auf dem Monitor angebracht sind. Diese bewirken, dass Licht von jeweils geradzahligen bzw. ungeradzahligen Spalten in das linke bzw. rechte Auge gelenkt wird. Zur Betrachtung ist nun keine Brille erforderlich, jedoch steht dem Betrachter nur ein enges Blickfeld zur Verfügung - bei seitlicher Betrachtung funktioniert das Verfahren nicht. Während die Bildwiederholfrequenz bei diesem Verfahren konstant bleibt, sinkt die Bildauflösung auf die Hälfte.

Die hier vorgeschlagenen Herstellungsverfahren für Polarisationsfilterarrays ermöglichen eine alternative Ausgestaltung von stereoskopischen Displays, bei denen das erzeugte Licht abwechselnd mit 90° verdrehter Ausrichtung, z. B. senkrecht und waagerecht, polarisiert wird. Dies kann zeilen- oder spaltenweise geschehen. Eine weitere vorteilhafte Ausgestaltung ergibt sich bei mosaikartiger Anordnung, da das Auge hierbei nicht mehr so leicht die Struktur der Bilderzeugung wahrnimmt (vgl. Bildqualität von Loch- und Streifenmaske). Zur Betrachtung ist eine Brille erforderlich, die je Auge ein Polfilter mit korrekter Ausrichtung für das jeweilige Halbbild aufweist. Eine Stromversorgung der Brille oder eine Synchronisation mit dem Monitor ist nicht erforderlich. Zudem kann der Betrachter sich frei im Raum bewegen. Lediglich starke seitliche Neigung des Kopfes führt zu Darstellungsfehlern. Die Bildwiederholfrequenz bleibt bei diesem Verfahren gleich, die Auflösung halbiert sich bei Verwendung von zwei orthogonalen Polfilterorientierungen. Wird die Brille abgenommen, kann mit dem Monitor jedoch ein zweidimensionales Bild mit der ursprünglichen Auflösung betrachtet werden - das menschliche Auge nimmt die unterschiedliche Polarisierung nicht wahr.

Die Anwendung ist dabei nicht auf Röhren- oder LED-Monitore beschränkt, die prinzipiell unpolarisiertes Licht erzeugen. Auch LCD-Displays, die inhärent bereits mit Polfiltern ausgestattet sind und folglich polarisiertes Licht erzeugen, können mit zusätzlichen Polfiltern in zueinander ortogonaler Orientierung versehen werden, wenn die einzelnen selektiven Filter gegenüber dem ganzflächigen Filter um +45° bzw. -45° verdreht sind.

Da die Trennung von linkem und rechtem Bild, ähnlich wie bei Verwendung einer Shutterbrille, fast ideal ist, bieten sich exotische andere Anwendungen an. Die beiden Halbbilder müssen nicht zwangsläufig zu einer stereoskopischen Darstellung desselben Objekts gehören - sie können komplett unabhängig sein. So kann etwa ein Halbbild einen Film wiedergeben, während das andere Halbbild einen Nachrichtentext zeigt. Der Betrachter kann so zwei unterschiedliche Szenen gleichzeitig wahrnehmen, sich auf eine Szene konzentrieren, aber auf plötzliche Ereignisse in der anderen Szene unmittelbar reagieren. Dies ist gleichsam eine Bild-neben-Bild- anstelle der bekannten Bild-im-Bild-Darstellung.

Wird die Polfilterbrille mit stufenweise drehbaren Filtern ausgestattet, so ergeben sich weitere interessante Möglichkeiten. Neben der stereoskopischen Darstellung (und einer inversen stereoskopischen Darstellung) gibt es nun die Möglichkeit, mit beiden Augen entweder Szene 1 oder Szene 2 zu verfolgen. So könnte eine Szene zeitgleich aus zwei völlig unterschiedlichen Perspektiven dargestellt werden, und jeder Beobachter kann sich frei entscheiden, welche Perspektive er sehen möchte. Ein Fernseher mit mehreren Empfängern oder ein Monitor kann, bei vorzugsweiser Verwendung von Kopfhörern, zeitgleich zwei komplett unterschiedliche Filme wiedergeben. Im Freizeit- und Computerbereich sowie in der Medizintechnik ergeben sich vielfältige Möglichkeiten.

Wenn der Monitor analog zur Kamera nach Beispiel 5 mit vier Filtern ausgestattet ist, so ist bei Darstellung eines stereoskopischen Signals nicht mit dem Verlust von 50% der Auflösung bzw. Bildhelligkeit verbunden, sofern die jeweils diagonal zur Brille polarisierten Pixel eine Mischinformation aus den korrekt orientierten Pixeln wiedergeben. Dies erfordert jedoch eine spezielle Verarbeitung der stereoskopischen Halbbilder vor der Darstellung.

Eine analoge Anwendung auf Projektoren ist ebenfalls möglich. Hierbei liegen die Polfilter nicht zwangsläufig zwischen Lichtquelle und Betrachter, stattdessen kann Licht durch ein Polfilterarray mit wechselnden Orientierungen der Polarisationsebene auf eine Leinwand projiziert werden. Nach der Reflexion tritt das Licht erneut durch dasselbe Filterelement und gelangt zum Betrachter, der mit einer Brille mit entsprechend orientierten Polfiltern ausgestattet ist. Der Projektor bzw. Die Bildauflösung muss hierbei auf die Leinwand abgestimmt werden, so dass einzelne Pixel, die zu einem bestimmten Halbbild gehören, auf die passenden Bereiche der Leinwand treffen. Im Gegensatz zu einer Integration des Polfilterarrays in den Projektor erlaubt das Filter vor der Leinwand eine größere Helligkeit, ohne dass Wärmeprobleme durch absorbiertes Licht auftreten.

### Beispiel 7: Projektion von stereoskopischen Bildern

Die bauliche Einheit von Bildgeber und Polarisationsfilter ist zur Projektion von Bildern auf eine große Fläche ungeeignet, da sich das Polfilter durch die Absorption von ungeeignet polarisiertem Licht erwärmt. Es ist daher sinnvoll, die Polfilterfläche zu vergrößern. Die maximale Größe kann das Filter unmittelbar vor der Projektionsfläche oder Leinwand annehmen.

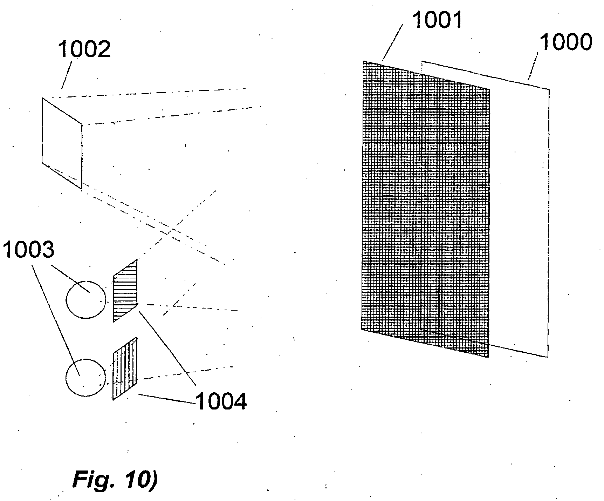

In diesem Fall ist es auch nicht relevant, ob die Projektionsfläche oder Leinwand die Polarisationsebene des Lichtes erhält oder nicht, da das reflektierte Licht auf dem Weg zum Betrachter erneut durch das Filter tritt. Die Anordnung ist in **Fig. 10** dargestellt. Ein Projektor 1002 projiziert ein Bild auf die Mattscheibe 1000, wobei das Licht zuvor durch eine Polfiltermatrix 1001 gelangt. Vorzugsweise werden in der Polfiltermatrix abwechselnd orthogonal zueinander polarisierte Filterbereiche verwendet, wobei jeder dieser Bereiche gewissermaßen einem Bildpunkt entspricht. Der Projektor muss nun alle Bildinformationen, die zu einem bestimmten stereoskopischen Halbbild gehören, durch einen passend polarisierten Bereich des Polfilters projizieren. Schaut der Betrachter 1003 durch eine Brille mit geeignet polarisierten Filtern 1004 auf die Projektionsfläche 1000, so kann er ein räumliches Bild wahrnehmen, wobei seine Position relativ zur Projektionsfläche unerheblich ist. Projektor und Leinwand müssen jedoch in der Auflösung aufeinander abgestimmt sein. Zur Erzeugung der beiden Halbbilder kann daher vorzugsweise ein digitaler Projektor verwendet werden, dessen Bild pixelweise definiert ist und bei dem für jedes Pixel ein passend polarisierter Bereich auf der Projektionsfläche existiert. Insbesondere bei Verwendung analoger Projektoren ist auch die Verwendung zweier Lochblenden sinnvoll, die das Signal jeweils eines Projektors nur zu den zugehörigen Bereichen der Projektionsfläche durchlassen und Anteile, die auf nicht zugehörige Bereiche projiziert würden, reflektieren oder absorbieren.

## Patentansprüche

1. Integrierte Schaltung zur Messung der Polarisation von Licht
- mit mindestens zwei polarisationsempfindlichen Sensoren mit unterschiedlicher Ausrichtung der Polarisationsebenen,
- wobei in der integrierten Schaltung Einrichtungen vorhanden sind, die konfiguriert sind, aus den Signalen der polarisationsempfindlichen Sensoren eine Aussage über die Polarisation des einfallenden Lichtes zu treffen,
- mit mindestens einem sensorischen Element (105), das mit einem Polarisationsfilter (102) zu einem der polarisationsempfindlichen Sensoren als bauliche Einheit zusammenwirkend angeordnet ist,
- wobei das polarisationsempfindliche Filter (102) des als bauliche Einheit angeordneten polarisationsempfindlichen Sensors eine gezielte Ausdehnung und Orientierung aufweist,
- wobei das Polarisationsfilter (102) mit lithographischen Methoden erzeugte Gitterstrukturen in mindestens einer Fertigungsebene und/oder Verdrahtungsebene aufweist,
- wobei zwischen den Bereichen mit Gitterstrukturen (102) lichtundurchlässige Wände (106) vorhanden sind, die bei schrägem Lichteinfall eine Beeinflussung benachbarter Sensoren (105) unterbinden, und
- wobei die lichtundurchlässigen Wände durch Vias bzw. Kontakte hergestellt sind.

2. Integrierte Schaltung nach Anspruch 1, **dadurch gekennzeichnet, dass** die Gitterstrukturen (102) aus einem ferromagnetischen Material bestehen.

3. Integrierte Schaltung nach einem der vorangehenden Ansprüche, **dadurch gekennzeichnet, dass** die zur Polarisation genutzten Leiterbahnen (102) kammartig verschaltet sind.

4. Integrierte Schaltung nach einem der vorangehenden Ansprüche, **dadurch gekennzeichnet, dass** die zur Polarisation genutzten Leiterbahnen (102) so verschaltet sind, dass sie von einem Heizstrom durchflossen werden können.

5. Integrierte Schaltung nach einem der vorangehenden Ansprüche, **dadurch gekennzeichnet, dass** als ein Dielektrikum zwischen den leitfähigen polarisierenden Strukturen (102) des Polarisationsfilters ein Material mit niedrigem Brechungsindex verwendet wird, das zu einer aufgeschäumten oder porösen Substanz als Metamaterial mit noch niedrigerer Dielektrizitätskonstante umgeformt ist.

6. Integrierte Schaltung nach einem der vorangehenden Ansprüche, **dadurch gekennzeichnet, dass** eine Vielzahl von polarisationsempfindlichen Sensoren vorhanden sind und so angeordnet und dergestalt orientiert sind, dass sie zur Aufnahme eines Bildes mit Informationen über die Polarisation des einfallenden Lichtes geeignet sind.

7. Integrierte Schaltung nach einem der vorangehenden Ansprüche, **dadurch gekennzeichnet, dass** mindestens ein Farbfilter vorhanden ist.

8. Integrierte Schaltung nach einem der vorangehenden Ansprüche, **dadurch gekennzeichnet, dass** die polarisationsempfindlichen Sensoren zusammen mit einer Vorrichtung zur Ansteuerung eines Aktuators und zum Vergleich des Messsignals mit einer Sollgröße zusammenwirkend angeordnet sind.

9. Integrierte Schaltung nach einem der vorangehenden Ansprüche, **dadurch gekennzeichnet, dass** Mittel zur elektronischen Kalibration und/oder Speicher zur Speicherung von Kalibrationsdaten vorhanden sind.

10. Integrierte Schaltung nach einem der vorangehenden Ansprüche, **dadurch gekennzeichnet, dass** Mittel zur automatischen Kalibration vorhanden sind.

11. Vorrichtung, umfassend:
- eine integrierte Schaltung nach einem der vorangehenden Ansprüche,
- ein Lichtemitter (402), und
- ein drehbares Polarisationsfilter (405), welches zwischen Lichtemitter (402) und polarisationsempfindlichem Sensor (401) angeordnet ist.

12. Verwendung einer integrierten Schaltung nach einem der Ansprüche 1 bis 10 oder der Vorrichtung gemäß Anspruch 11 zum Ermitteln des Drehwinkels zwischen einem polarisierten Lichtemitter und dem polarisationsempfindlichen Sensor mit Hilfe der Polarisation des von dem polarisierten Lichtemitter emittierten Lichts.

13. Verwendung einer integrierten Schaltung nach einem der Ansprüche 1 bis 10 oder der Vorrichtung gemäß Anspruch 11 zum Erfassen des von einem Emitter (702) ausgehenden Lichts durch mindestens einen polarisationsempfindlichen Sensor (703), nachdem das Licht an einem reflektierenden Medium (701) reflektiert worden ist und durch ein drehbares Polarisationsfilter (700) getreten ist.

14. Verwendung einer integrierten Schaltung nach einem der Ansprüche 1 bis 10 oder der Vorrichtung gemäß Anspruch 11 zur Messung von Magnetfeldern unter Ausnutzung des Faradayeffekts.

15. Verwendung einer integrierten Schaltung nach einem der Ansprüche 1 bis 10 oder der Vorrichtung gemäß Anspruch 11 zur Messung von elektrischen Feldern nach dem Kerreffekt.

## Claims

1. Integrated circuit for the measurement of the polarization of light
- with at least two polarization-sensitive sensors with different orientation of the polarization planes,
- wherein arrangements exist in the integrated circuit that are configured to make a statement about the polarization of the incident light from the signals of the polarization-sensitive sensors,
- with at least one sensor element (105) that is positioned with a polarization filter (102) with one of the polarization-sensitive sensors into a constructional unit,
- wherein the polarization-sensitive filter (102) of the polarization-sensitive sensor positioned as a constructional unit has a targeted expansion and orientation,
- wherein the polarization filter (102) has grating structures created with lithographic methods in at least one production layer and/or wiring layer,
- wherein between the areas with grating structures (102) there are opaque walls (106) that suppress an influence of adjacent sensors (105) in the case of angular lighting, and
- wherein the opaque walls are made of vias or contacts, respectively.

2. Integrated circuit according to Claim 1, **characterized in that** the grating structures (102) consist of a ferromagnetic material.

3. Integrated circuit according to one of the previous claims, **characterized in that** the conducting paths (102) used for polarization are interconnected in a comb-like way.

4. Integrated circuit according to one of the previous claims, **characterized in that** the conducting paths (102) used for polarization are interconnected in such a way that they could be flown through with a heating current.

5. Integrated circuit according to one of the previous claims, **characterized in that** a material with a low refractive index that is reformed into a foamed or porous substance as metamaterial with an even lower dielectric constant is used as a dielectric medium between the conducting polarizing structures (102) of the polarizing filter.

6. Integrated circuit according to one of the previous claims, **characterized in that** a plurality of polarization-sensitive sensors are present and arranged and oriented in such a way that they are suited for the capture of a picture with information about the polarization of the incoming light.

7. Integrated circuit according to one of the previous claims, **characterized in that** at least one color filter is present.

8. Integrated circuit according to one of the previous claims, **characterized in that** the polarization-sensitive sensors are arranged coactively along with an apparatus for controlling of an actuator and for the comparison of the measurement signal with a nominal value.

9. Integrated circuit according to one of the previous claims, **characterized in that** means for electronic calibration and/or storage for the storage of calibration data are present.

10. Integrated circuit according to one of the previous claims, **characterized in that** means for automatic calibration are present.

11. Apparatus comprising:
- an integrated circuit according to one of the previous claims,
- a light emitter (402), and
- a rotatable polarization filter (405), which is arranged between the light emitter (402) and the sensor sensitive to polarization (401).

12. Use of an integrated circuit according to one of Claims 1 to 10 or the apparatus according to Claim 11 for the determination of the rotating angle between a polarizing light emitter and the polarization-sensitive sensor with the help of the polarization of the light emitted from the polarizing light emitter.

13. Use of an integrated circuit according to one of Claims 1 to 10 or of the apparatus according to Claim 11 for the determination of the light coming from an emitter (702) by at least one polarization-sensitive sensor (703), after the light has been reflected in a reflecting medium (701) and has penetrated a rotatable polarization filter (700).

14. Use of an integrated circuit according to one of Claims 1 to 10 or the apparatus according to Claim 11 for the measurement of magnetic fields under the utilization of the Faraday-effect.

15. Use of an integrated circuit according to one of Claims 1 to 10 or the apparatus according to Claim 11 for the measurement of electrical fields according to the Kerr effect.

## Revendications

1. Circuit intégré pour la mesure de la polarisation de la lumière
- avec au moins deux capteurs sensibles à la polarisation affichant différentes directions des niveaux de polarisation,
- étant entendu que sont présents dans le circuit intégré des équipements configurés de sorte à obtenir un résultat sur la polarisation de la lumière incidente à partir des signaux issus des capteurs sensibles à la polarisation,
- avec au moins un élément sensoriel (105) monté en combinaison unitaire avec un filtre polarisant (102) résultant en l'un des capteurs sensibles à la polarisation,
- étant entendu que le filtre sensible à la polarisation (102) du capteur sensible à la polarisation en combinaison unitaire affiche une extension précise et une orientation,
- étant entendu que le filtre polarisant (102) comprend des structures en grilles réalisées par méthodes lithographiques dans au moins une couche de fabrication et / ou de câblage,
- étant entendu qu'entre les secteurs en structure de grille (102) se trouvent des parois non perméables à la lumière (106) évitant lors d'une incidence latérale de lumière d'influencer les capteurs voisins (105), et
- étant entendu que les parois non perméables à la lumière sont constituées de traversées ou de contacts, respectivement.

2. Circuit intégré selon la revendication n° 1, **caractérisé en ce que** les structures en grilles (102) soient en matériaux ferromagnétique.

3. Circuit intégré selon l'une des revendications précédentes, **caractérisé en ce que** les pistes conductrices (102) utilisées pour la polarisation soient câblée en forme de peigne.

4. Circuit intégré selon l'une des revendications précédentes, **caractérisé en ce que** les pistes conductrices (102) utilisées pour la polarisation soient câblées par des câbles chauffants.

5. Circuit intégré selon l'une des revendications précédentes, **caractérisé en ce que** comme diélectrique entre les structures polarisantes conductrices (102) du filtre polarisant un matériau soit utilisé avec un faible indice de réfraction transformé en une substance moussée et poreuse en métamatériaux affichant une constante diélectrique encore plus faible.

6. Circuit intégré selon l'une des revendications précédentes, **caractérisé en ce qu'**un grand nombre de capteurs sensibles à la polarisation soient présents et positionnés et orientés de façon à être apte à fixer une image comportant les informations sur la polarisation de la lumière incidente.

7. Circuit intégré selon l'une des revendications précédentes, **caractérisé en ce qu'**au moins un filtre couleur soit présent.

8. Circuit intégré selon l'une des revendications précédentes, **caractérisé en ce que** les capteurs sensibles à la polarisation soient tous positionnés avec un dispositif de commande d'un actionneur et à titre de comparaison du signal mesuré avec une donnée indicative.

9. Circuit intégré selon l'une des revendications précédentes, **caractérisé en ce que** des moyens sont à disposition pour la calibration électronique et / ou une mémoire pour sauvegarder des données de calibration.

10. Circuit intégré selon l'une des revendications précédentes, **caractérisé en ce que** des moyens soient à disposition pour la calibration automatique.

11. Dispositif comprenant :
- un circuit intégré selon l'une des revendications précédentes,
- un émetteur de lumière (402), et
- un filtre rotatif de polarisation (405) positionné entre l'émetteur de lumière (402) et le capteur sensible à la polarisation (401).

12. Recours à un circuit intégré selon les revendications n°1 à n°10 ou du dispositif selon la revendication n°11 pour évaluer l'angle de rotation entre un émetteur de lumière polarisé et le capteur sensible à la polarisation à l'aide de la polarisation de la lumière émise par l'émetteur de lumière polarisé.

13. Recours à un circuit intégré selon les revendications n°1 à n°10 ou du dispositif selon la revendication n°11 pour saisir la lumière émise par un émetteur (702) au moyen d'au moins un capteur sensible à la polarisation (703) après que la lumière ait été reflétée par un medium reflétant (701) et soit passée à travers un filtre rotatif à polarisation (700).

14. Recours à un circuit intégré selon les revendications n°1 à n°10 ou du dispositif selon la revendication n°11 pour mesurer les champs magnétiques en utilisant l'effet Faraday.

15. Recours à un circuit intégré selon les revendications n°1 à n°10 ou du dispositif selon la revendication n°11 pour mesurer les champs électriques selon l'effet Kerr.
